# EUROPÄISCHE PATENTSCHRIFT

(11) **EP 2 783 915 B1**
(45) Veröffentlichungstag und Bekanntmachung des Hinweises auf die Patenterteilung: **05.08.2015**
(21) Anmeldenummer: 13161022.2
(22) Anmeldetag: 26.03.2013
(51) Int. Cl.: B60Q 11/00, G01R 31/44, G01R 31/00, H05B 33/08, H05B 37/03

(54) **Verfahren zur Erzeugung eines Diagnosesignals einer Kraftfahrzeugleuchte mit mehreren Leuchtmitteln sowie Kraftfahrzeugleuchte**
Method for generating a diagnosis signal of a motor vehicle light with a plurality of lamps and motor vehicle light
Procédé de génération d'un signal de diagnostic d'une lampe de véhicule automobile dotée de plusieurs moyens d'éclairage et lampe de véhicule automobile

(43) Veröffentlichungstag der Anmeldung: 01.10.2014
(73) Patentinhaber: odelo GmbH, 70329 Stuttgart (DE)
(72) Erfinder: Gönczi, Attila, 71336 Waiblingen (DE)
(74) Vertreter: Benninger, Johannes

(56) Entgegenhaltungen:
- EP-A1- 2 096 898
- DE-A1- 19 643 908
- DE-A1-102005 036 692
- DE-A1-102007 012 913
- US-A1- 2006 181 889

## Beschreibung

Die Erfindung betrifft ein Verfahren zur Erzeugung eines von einer Kraftfahrzeugleuchte mit mehreren Leuchtmitteln an ein Steuergerät eines Kraftfahrzeugs via einer einzigen Diagnoseleitung übertragbaren Diagnosesignals gemäß dem Oberbegriff des Anspruchs 1 sowie eine Kraftfahrzeugleuchte zur Ausführung eines solchen Verfahrens gemäß dem Oberbegriff des Anspruchs 10.

Jede Kraftfahrzeugleuchte erfüllt je nach Ausgestaltung eine oder mehrere Aufgaben bzw. Funktionen, zu deren Erfüllung je mindestens eine Lichtfunktion der Kraftfahrzeugleuchte vorgesehen ist. Lichtfunktionen sind beispielsweise bei einer Ausgestaltung als Scheinwerfer eine die Fahrbahn ausleuchtende Funktion, oder bei einer Ausgestaltung als Signalleuchte eine Signalfunktion, wie beispielsweise eine Wiederholblinklichtfunktion zur Fahrtrichtungsanzeige oder eine Bremslichtfunktion zur Anzeige einer Bremstätigkeit, oder z.B. einer Begrenzungslichtfunktion, wie etwa einer Rücklichtfunktion, zur Sicherstellung einer Sichtbarkeit des Kraftfahrzeugs bei Tag und/oder Nacht, wie etwa bei einer Ausgestaltung als Heckleuchte oder Tagfahrleuchte. Jede Lichtfunktion muss dabei eine beispielsweise gesetzlich vorgegebene Lichtverteilung erfüllen. Die Lichtverteilung legt dabei mindestens einzuhaltende, umgangssprachlich als Helligkeit bezeichnete Lichtströme in zumindest einzuhaltenden Raumwinkelbereichen fest.

Beispiele für Kraftfahrzeugleuchten sind am Fahrzeugbug, an den Fahrzeugflanken und/oder an den Seitenspiegeln sowie am Fahrzeugheck angeordnete Wiederholblinkleuchten, Ausstiegsleuchten, beispielsweise zur Umfeldbeleuchtung, Begrenzungsleuchten, Bremsleuchten, Nebelleuchten, Rückfahrleuchten, sowie typischerweise hoch gesetzte dritte Bremsleuchten, so genannte Central, High-Mounted Braking Lights, Tagfahrleuchten, Scheinwerfer und auch als Abbiege- oder Kurvenlicht verwendete Nebelscheinwerfer, sowie Kombinationen hiervon.

Eine Kraftfahrzeugleuchte umfasst im Wesentlichen einen von einem Leuchtengehäuse und einer Lichtscheibe umschlossenen Leuchteninnenraum und mindestens ein darin beherbergtes, mindestens eine Lichtquelle umfassendes Leuchtmittel für wenigstens eine Lichtfunktion der Kraftfahrzeugleuchte.

Wenigstens einer Lichtquelle des Leuchtmittels können ein oder mehrere zur Ausformung einer beispielsweise gesetzlich vorgegebenen Lichtverteilung beitragende Optikelemente zur Lichtlenkung zugeordnet sein.

Bei den erwähnten Optikelementen kann es sich um wenigstens einen Reflektor und/oder um mindestens eine optische Linse und/oder um eine oder mehrere im Strahlengang zwischen wenigstens einer Lichtquelle des Leuchtmittels und der Lichtscheibe angeordnete Optikscheiben und/oder um wenigstens ein optisches Prisma und/oder um einen Lichtleiter handeln, um nur einige denkbare Ausführungsformen zu nennen, sowie Kombinationen hiervon.

Beispielsweise kann in dem Leuchteninnenraum mindestens ein hinter wenigstens einer Lichtquelle zumindest eines Leuchtmittels angeordneter Reflektor untergebracht sein. Der Reflektor kann zumindest zum Teil durch ein separates Bauteil und/oder durch wenigstens einen Teil des Leuchtengehäuses selbst gebildet sein, beispielsweise vermittels einer zumindest teilweisen, reflektierenden Beschichtung.

Die Lichtscheibe ist durch eine heutzutage meist aus einem Kunststoff hergestellte, transparente Abdeckung gebildet, welche den Leuchteninnenraum abschließt und die darin beherbergten Bauteile, wie etwa ein oder mehrere Leuchtmittel, Reflektoren sowie alternativ oder zusätzlich vorgesehene Optikelemente gegen Witterungseinflüsse schützt.

Die Lichtscheibe selbst kann alternativ oder zusätzlich als ein Optikelement ausgebildet sein, beispielsweise indem sie vorzugsweise an deren Innenseite mit einer zur Erzeugung einer oder mehrerer zuvor erwähnter gesetzlich vorgegebener Lichtverteilungen beitragenden optischen Struktur versehen ist. Hierdurch kann gegebenenfalls auf eine Optikscheibe verzichtet werden.

Als Lichtquellen kommen Glühlampen, Gasentladungslampen sowie unter anderem wegen ihres geringen Stromverbrauchs und geringen Bauraumbedarfs vermehrt Leuchtdioden zum Einsatz. Letztere bestehen aus mindestens einem Lichtemittierende-Diode-Halbleiter-Chip, kurz LED-Chip, sowie wenigstens einer beispielsweise durch Spritzgießen angeformten, den mindestens einen LED-Chip ganz oder teilweise umhüllenden Primäroptik. Auch sind Kraftfahrzeugleuchten bekannt, in denen reine LED-Chips ohne angeformte Primäroptiken zum Einsatz kommen. Im Folgenden wird deshalb der Einfachheit halber nicht mehr zwischen Leuchtdiode und LED-Chip unterschieden und statt dessen einheitlich der Begriff LED stellvertretend für beide Ausgestaltungen verwendet, es sei denn, es ist explizit etwas anderes erwähnt. Herausragende Eigenschaften von LEDs im Vergleich zu anderen, konventionellen Lichtquellen von Leuchtmitteln sind eine wesentlich längere Lebensdauer und eine wesentlich höhere Lichtausbeute bei gleicher Leistungsaufnahme. Dadurch und unter anderem auch wegen ihrer kompakteren Abmessungen können durch Verwendung von LEDs als Lichtquelle von Leuchtmitteln besonders kompakte Kraftfahrzeugleuchten verwirklicht werden, die an fast jede nur erdenkliche Einbausituation angepasst sein können.

Das Leuchtengehäuse bzw. der Leuchteninnenraum kann in mehrere Kammern mit jeweils eigenen Lichtquellen und/oder Leuchtmitteln und/oder Optikelementen sowie gegebenenfalls Lichtscheiben unterteilt sein, von denen mehrere Kammern gleiche und/oder jede Kammer eine andere Lichtfunktionen erfüllen kann.

Um eine gewünschte oder gesetzlich geforderte Lichtverteilung zu erzielen, ist es bekannt, mehrere beispielsweise gleichartige Lichtquellen in einem zur Erfüllung einer Lichtfunktion vorgesehenen Leuchtmittel zu verwenden.

Ein Beispiel hierfür sei nachfolgend anhand von als Lichtquellen vermehrt zum Einsatz kommenden LEDs beschrieben. LEDs weisen typischerweise eine Betriebsspannung von 1 V bis 3 V auf, weshalb es zur besseren Ausnutzung der vorherrschenden Spannung im Bordnetz von Kraftfahrzeugen üblich ist, mehrere, beispielsweise drei oder vier LEDs zu einem so genannten LED-Strang in Reihe bzw. in Serie zu schalten. Je nach zur Erzeugung einer bestimmten Lichtstärke erforderlicher Anzahl von LEDs werden mehrere solche LED-Stränge parallel geschaltet. Eine gemeinsame Stromzuführung parallel geschalteter LED-Stränge verzweigt sich auf die nachfolgend LED-Zweige genannten einzelnen LED-Stränge.

Ein anschauliches Beispiel ist eine Heckleuchte, bei der insgesamt fünfzehn LEDs aufgeteilt in fünf parallel geschaltete LED-Zweige zu je drei in Reihe geschalteten LEDs als Lichtquellen eines Leuchtmittels zur Erfüllung einer Rücklichtfunktion verwendet werden.

Problematisch bei der Verwendung mehrerer derart zu einem Feld verschalteter LEDs bzw. allgemeiner Lichtquellen in einem Leuchtmittel ist der Ausfall einzelner Lichtquellen bzw. eine hierfür erforderliche Ausfallerkennung. Fällt eine Lichtquelle z.B. hochohmig aus, entsprechend einem Durchbrennen, fließt durch den zugehörigen Lichtquellen-Zweig kein Strom mehr, wodurch die verbleibenden Lichtquellen im gesamten zugehörigen Lichtquellen-Zweig dunkel bleiben oder ausgehen und sich die Leuchtstärke der Lichtfunktion verringert. Fällt eine Lichtquelle z.B. niederohmig aus, entsprechend einem Kurzschluss, liegt an den verbleibenden Lichtquellen im zugehörigen Lichtquellen-Zweig eine höhere Spannung an, als deren Betriebsspannung. Dadurch kann durch die verbleibenden Lichtquellen zunächst ein höherer Strom als bei deren Betriebsspannung fließen. Durch diesen höheren Strom können die verbleibenden Lichtquellen zunächst heller leuchten, wodurch das niederohmige Ausfallen einer Lichtquelle zunächst verborgen bleiben kann. Der höhere Strom führt jedoch früher oder später meist zu einer Zerstörung zumindest einer der verbleibenden Lichtquellen im zugehörigen Lichtquellen-Zweig, wodurch die Leuchtstärke der Lichtfunktion auch bei einem niederohmigen Ausfall innerhalb absehbarer Zeit verringert wird.

Durch DE 40 35 673 A1 ist eine Ausfallerkennung für elektrische Verbraucher bekannt. Die elektrischen Verbraucher sind parallel geschaltet und verfügen über getrennte Stromzuführungen. Jedem elektrischen Verbraucher ist ein Stromsensor zugeordnet, der bei Stromdurchfluss in der überwachten Stromzuführung einen anderen Widerstandswert besitzt, als im stromlosen Zustand der überwachten Stromzuführung. Die Stromsensoren weisen unterschiedliche Widerstandswerte bei Stromdurchfluss in den überwachten Stromzuführungen auf. Die Stromsensoren sind parallel zu einer Spannungsteilerschaltung geschaltet, so dass eine Auswertung unterschiedliche Spannungen in Abhängigkeit von den Stromdurchflüssen durch die einzelnen Stromzuführungen ergibt. Die Messung erfolgt dabei indirekt über in den Stromzuführungen angeordnete Spulen sowie in den Magnetfeldern der stromdurchflossenen Spulen angeordnete Reed-Kontakte als Stromsensoren.

Durch DE 101 31 824 A1 ist eine Ausfallerkennung von LEDs in einem Kraftfahrzeug bekannt. Dabei wird ein elektrisches Potential in einem LED-Zweig aus einer oder mehreren in Reihe geschalteten LEDs erfasst. Gleichzeitig wird ein von der Spannung des Bordnetzes abhängiges Referenzpotential erfasst. Zur Ausfallerkennung wird das elektrische Potential in dem LED-Zweig mit dem Referenzpotential verglichen. Hierdurch werden Bordnetzschwankungen ausgeglichen. In Abhängigkeit von diesem Vergleich wird ein Signal ausgegeben, wenn mindestens eine LED in dem LED-Zweig ausfällt.

Dabei ist zur Ausfallerkennung mehrerer von einer Stromzuführung gespeister paralleler Zweige mit jeweils einem oder mehreren in Reihe geschalteten Leuchtmitteln für jeden Zweig eine eigene aufwändige Schaltungsanordnung notwendig. Bei DE 40 35 673 A1 ist dies die Schaltungsanordnung für die indirekte Messung, bei DE 101 31 824 A1 ist dies der für jeden Zweig erforderliche eigene Abgriff und Vergleich mit dem Referenzpotential.

Durch EP 2 096 898 A1 ist ein Beleuchtungssystem für Fahrzeuge beschrieben, einschließlich einer Beleuchtungseinrichtung mit mindestens einer Leuchtdiode und einer Steuereinrichtung der Beleuchtungseinrichtung. Die Steuereinrichtung misst die Spannung an den Anschlüssen aller Zweige, vergleicht sie mit dem Schwellenwert und weist jedem Messspannungswert ein binärer Wert "1" oder "0" auf der Basis des Ergebnisses eines solchen Vergleichs, dann erzeugt einen Bitstrom auf der Basis der binären Werte zugeordnet den gemessenen Spannungen und analysiert den Bitstrom, um den ordnungsgemäßen Betrieb oder eine Fehlfunktion der einzelnen Zweige zu diagnostizieren.

Durch EP 2 247 161 A1 sind ein Verfahren und eine Schaltungsanordnung zur Ausfallerkennung für Lichtquellen eines Leuchtmittels in Kraftfahrzeugleuchten bekannt. Dabei wird der Ausfall einer Lichtquelle von mehreren Lichtquellen erkannt, die in mehreren parallelen, identisch aufgebauten Zweigen bestehend aus jeweils mindestens einer in Reihe geschalteten Lichtquelle angeordnet und mit einer Stromquelle verbunden sind. Das Verfahren sieht vor, ein erstes elektrisches Potential in einem ersten Zweig zu erfassen und mit einem in einem zweiten Zweig mit einem dem ersten Zweig identischen Aufbau erfassten, zweiten elektrischen Potential zu vergleichen. Bei einer Abweichung der Potentiale zweier Zweige um einen vorgegebenen Betrag wird ein Ausfall erkannt. Ausgehend von einer Betriebsspannung und/oder eines Spannungsabfalls der einzelnen Lichtquellen ist dabei ein Potentialsollwert der Zweige vorgegeben, mit dem die erfassten Potentiale der Zweige verglichen werden. Zusätzlich wird eine Versorgungsspannung oder eine unmittelbar von der Versorgungsspannung abhängige Vergleichsspannung für einen Vergleich unter Kenntnis des Spannungsabfalls der überwachten Lichtquellen und der Versorgungsspannung herangezogen. Die Schaltungsanordnung umfasst neben zu identisch aufgebauten, parallel geschalteten Zweigen geschaltete und mit einer Stromquelle verbundenen Lichtquellen eines Leuchtmittels eine Kontrollelektronik, die über eine Stromzuführung ebenfalls mit der Stromquelle verbunden ist. Die Kontrollelektronik ist über eine Verbindungsleitung mit den Zweigen verbunden. Zwischen der Verbindungsleitung und den Zweigen sind jeweils Schalter angeordnet, welche von der Kontrollelektronik über Steuerleitungen einzeln nacheinander durchgeschaltet werden. An einem Eingang der Kontrollelektronik wird dadurch jeweils ein Potential eines Zweigs erfasst.

Mit einer der zuvor beschriebenen Ausfallerkennungen kann der Ausfall eines Leuchtmittels erfasst werden, das eine oder mehrere Lichtquellen aufweist.

Um einen erfassten Ausfall eines Leuchtmittels einer Kraftfahrzeugleuchte einem Steuergerät eines Kraftfahrzeugs mitzuteilen, ist eine separate Diagnoseleitung notwendig, über welche vermittels eines Diagnosesignals ein erfasster Ausfall dem Steuergerät mitgeteilt wird. Die Kraftfahrzeugleuchte kann hierzu über eine Diagnoseschnittstelle verfügen, an welche die Diagnoseleitung angeschlossen ist.

Nachteilig hieran ist, dass zur dezidierten Mitteilung des Ausfalls eines bestimmten Leuchtmittels von mehreren, zur Erfüllung unterschiedlicher und/oder gleicher Lichtfunktionen einer Kraftfahrzeugleuchte vorgesehener Leuchtmittel bzw. einer oder mehrerer Lichtquellen dessen einer oder mehrerer Lichtquellen eines bestimmten Leuchtmittels von mehreren, zur Erfüllung unterschiedlicher und/oder gleicher Lichtfunktionen einer Kraftfahrzeugleuchte vorgesehener Leuchtmittel, jeweils eigene, jeweils einem Leuchtmittel zugeordnete Diagnoseleitungen erforderlich sind.

Dies steht einer angestrebten Rationalisierung und Vereinfachung in der Automobilindustrie entgegen, welche Rationalisierung eine einfache, zeitsparende und kostengünstige Herstellung, Lagerhaltung und Montage zum Ziel hat. Eine Vielzahl von Diagnoseleitungen sowie entsprechend ausgestattete Kabelbäume stehen diesem Ziel entgegen.

Alternativ ist denkbar, beispielsweise einen digitalen Code oder ein analoges Signal mit einem aufmodulierten Code über nur eine Diagnoseleitung zu übertragen, welcher bzw. welches eine eindeutige Identifikation eines ausgefallenen Leuchtmittels erlaubt.

Nachteilig hieran ist der hohe Kostenaufwand, der dadurch bedingt ist, dass in jeder Kraftfahrzeugleuchte entsprechende Prozessoren verbaut werden müssen, welche ein entsprechendes digitales oder z.B. hochfrequent aufmoduliertes Diagnosesignal erzeugen.

Darüber hinaus stellt die Übertragung eines Diagnosesignals bei erfasstem Ausfall oder bei erfasstem Sollbetrieb eines Leuchtmittels nicht sicher, dass der Zustand des Leuchtmittels tatsächlich demjenigen Zustand entspricht, den das Steuergerät anhand des Empfangs oder Nichtempfangs des Diagnosesignals annimmt, da beispielsweise eine Unterbrechung der Diagnoseleitung zu einer fehlerhaften Annahme führen kann.

Ein weiterer Nachteil des Standes der Technik ist, dass insbesondere LEDs eine zu geringe Stromaufnahme aufweisen, um anhand ihres Stromverbrauchs überhaupt von einem Steuergerät erkannt werden zu können. Deshalb werden bei Leuchtmitteln, die insbesondere ausschließlich LEDs als Lichtquellen verwenden, häufig Blindwiderstände verbaut, so genannte Dummywiderstände, die einen bestimmten Strom verbrauchen, um eine Erkennung durch ein Steuergerät zu ermöglichen.

Der Erfindung liegt die Aufgabe zu Grunde, ein Verfahren zur Erzeugung eines zur Übertragung von einer Kraftfahrzeugleuchte mit mehreren Leuchtmitteln an ein Steuergerät eines Kraftfahrzeugs vorgesehenen, eindeutig einem oder mehreren Leuchtmitteln der Kraftfahrzeugleuchte zugeordneten Diagnosesignals zu entwickeln, welches Diagnosesignal einfach zu erzeugen ist, eine eindeutige Zuordnung des Zustands aller Leuchtmittel einer Kraftfahrzeugleuchte mit mindestens zwei zur Erfüllung beispielsweise unterschiedlicher Lichtfunktionen vorgesehener Leuchtmittel erlaubt, sowie den Stromverbrauch einer Kraftfahrzeugleuchte nicht nachteilig erhöht, und zu dessen Übertragung nur eine einzige Diagnoseleitung benötigt wird, sowie eine zur Ausführung eines solchen Verfahrens geeignete Kraftfahrzeugleuchte bereitzustellen.

Die Aufgabe wird jeweils gelöst mit den Merkmalen der unabhängigen Ansprüche.

Ein erster Gegenstand der Erfindung betrifft demnach ein Verfahren zur Erzeugung eines zur Übertragung von einer Kraftfahrzeugleuchte mit mehreren Leuchtmitteln an ein Steuergerät eines Kraftfahrzeugs via einer einzigen Diagnoseleitung vorgesehenen, eindeutig die Funktion oder Nichtfunktion eines oder mehrerer Leuchtmittel der Kraftfahrzeugleuchte identifizierenden Diagnosesignals.

Die Kraftfahrzeugleuchte umfasst mindestens zwei jeweils mit einer oder mehreren Lichtquellen ausgestattete Leuchtmittel zur Erfüllung mindestens einer Lichtfunktion der Kraftfahrzeugleuchte. Darüber hinaus umfasst die Kraftfahrzeugleuchte für wenigstens zwei der in ihr verbauten Leuchtmittel jeweils eine Ausfallerkennung, welche den Ausfall einer oder mehrerer oder aller Lichtquellen des jeweiligen, mit einer Ausfallerkennung ausgestatteten Leuchtmittels zu erfassen in der Lage sind und entweder ein Ausgangssignal im Gutzustand erzeugen, welches den ordnungsgemäßen Betrieb aller Lichtquellen des jeweiligen Leuchtmittels bei dessen Betrieb anzeigt, oder ein Ausgangssignal im Schlechtzustand erzeugen, welches den fehlerhaften Betrieb einer, mehrerer oder aller Lichtquellen des jeweiligen Leuchtmittels bei dessen Betrieb anzeigt.

Das Verfahren sieht ein Diagnosesignal in Form eines Diagnosestroms vor. Das Diagnosesignal entspricht dabei einem Summendiagnosestrom aus einem oder mehreren Einzeldiagnoseströmen. Liegt kein Einzeldiagnosestrom vor, gibt es auch keinen Summendiagnosestrom. Die Stromstärke eines Summendiagnosestroms des Diagnosesignals ergibt sich derart aus der Summe der Stromstärken eines oder mehrerer Einzeldiagnoseströme, dass jede sich aus jeder beliebigen Kombination von Einzeldiagnoseströmen ergebende Stromstärke des Summendiagnosestroms dabei eindeutig der einem Gutzustand entsprechenden Funktion oder der einem Schlechtzustand entsprechenden Nichtfunktion einer oder mehrerer exakt bestimmbarer Leuchtmittel aller vorhandener und mit jeweils einer Ausfallerkennung versehener Leuchtmittel zugeordnet ist.

Hierzu sieht das Verfahren vor, jeder Ausfallerkennung eines mit einer Ausfallerkennung ausgestatteten Leuchtmittels einen Einzeldiagnosestrom vorgegebener Stromstärke zuzuordnen, wobei jede Summe jeder beliebigen Kombination von den Ausfallerkennungen zugeordneten Einzeldiagnoseströmen eine Stromstärke des Summendiagnosestroms in einer solchen Höhe zur Folge hat, welche einen eindeutigen Rückschluss auf die ordnungsgemäß funktionierenden Leuchtmittel bzw. auf diejenigen Leuchtmittel, welche sich im Gutzustand befinden, sowie auf gegebenenfalls ausgefallene Leuchtmittel bzw. auf diejenigen Leuchtmittel, die sich im Schlechtzustand befinden, zulässt.

Dies kann beispielsweise erhalten werden, indem jeder Ausfallerkennung ein Einzeldiagnosestrom zugeordnet ist, dessen Stromstärke jeweils proportional einem individuellen Wert einer Potenzreihe ist. Die individuellen Werte der Potenzreihe sind dabei für verschiedene, jeweils einem Leuchtmittel zugeordnete Ausfallerkennungen unterschiedlich.

Als geeignete Potenzreihe kommt beispielsweise eine Zweierpotenzreihe in Frage, wie sie aus der Erzeugung von Zahlen des Dezimalsystems anhand von Binärzahlen bekannt ist, nachfolgend auch als Binärnummersystem bezeichnet. Demnach ist der Ausfallerkennung eines ersten Leuchtmittels beispielsweise ein Einzeldiagnosestrom mit einer beispielsweise einer ersten Potenz P1 von zwei eines Grundstromstärkeniveaus IG proportionalen Stromstärke zugeordnet, entsprechend einer Stromstärke in Höhe von P1*I Ampere ausgehend von dem Grundstromstärkeniveau IG. Der Ausfallerkennung eines zweiten Leuchtmittels ist beispielsweise ein Einzeldiagnosestrom mit einer beispielsweise einer zweiten Potenz P2 von zwei eines Grundstromstärkeniveaus IG proportionalen Stromstärke zugeordnet, entsprechend einer Stromstärke in Höhe von P2*I Ampere ausgehend vom Grundstromstärkeniveau IG. Weiteren Ausfallerkennungen dritter, vierter und so fort Leuchtmitteln sind beispielsweise jeweils Einzeldiagnoseströme mit einer beispielsweise einer dritten, vierten und so weiter Potenz PN von zwei eines Grundstromstärkeniveaus I proportionalen Stromstärke zugeordnet, entsprechend einer Stromstärke in Höhe von PN*I Ampere ausgehend vom Grundstromstärkeniveau IG.

Dementsprechend können bei beispielsweise vier unterschiedlichen Leuchtmittel zugeordneten Ausfallerkennungen der Ausfallerkennung:
- eines ersten Leuchtmittels ein Einzeldiagnosestrom mit einer Stromstärke in Höhe eines Faktors einer ersten Potenz von zwei, entsprechend zwei hoch eins, i.e. zwei, eines Grundstromstärkeniveaus IG in Höhe von 2*IG Ampere zugeordnet sein,
- eines zweiten Leuchtmittels ein Einzeldiagnosestrom mit einer Stromstärke in Höhe eines Faktors einer ersten Potenz von zwei, entsprechend zwei hoch zwei, i.e. vier, eines Grundstromstärkeniveaus IG in Höhe von 4*IG Ampere zugeordnet sein,
- eines dritten Leuchtmittels ein Einzeldiagnosestrom mit einer Stromstärke in Höhe eines Faktors einer dritten Potenz von zwei, entsprechend zwei hoch drei, i.e. acht, eines Grundstromstärkeniveaus IG in Höhe von 8*IG Ampere zugeordnet sein, und
- eines vierten Leuchtmittels ein Einzeldiagnosestrom mit einer Stromstärke in Höhe eines Faktors einer ersten Potenz von zwei, entsprechend zwei hoch vier, i.e. sechzehn, eines Grundstromstärkeniveaus IG in Höhe von 16*IG Ampere zugeordnet sein.

Jeder sich aus jeder beliebigen Kombination von Einzeldiagnosestrom mit Stromstärken solcher Höhe ergebende Summendiagnosestrom ist dabei eindeutig der Funktion oder der Nichtfunktion einer oder mehrerer aller vorhandener und mit jeweils einer Ausfallerkennung versehener Leuchtmittel zugeordnet.

Als Grundstromstärkeniveaus IG kommt beispielsweise eine Stromstärke in Höhe von 1 µA bis 1 A in Frage.

Vorzugsweise ist jeder Ausfallerkennung ihr jeweiliger Einzeldiagnosestrom derart zugeordnet, dass der entsprechende Einzeldiagnosestrom bei ordnungsgemäßer Funktion des jeweiligen Leuchtmittels fließt. Dies hat den Vorteil, dass insbesondere bei LEDs als Lichtquellen von Leuchtmitteln zumindest ein Teil des ansonsten nur zur Erkennung des Verbrauchers durch ein Steuergerät nur unnütz verbrauchten Stroms zur Erzeugung eines den ordnungsgemäßen Betrieb des jeweiligen Leuchtmittels anzeigenden Einzeldiagnosestroms der jeweiligen Ausfallerkennung verwendet wird. Durch Kenntnis der momentan benötigten, eingeschalteten Lichtfunktionen einhergehend mit der Kenntnis der zu deren Erfüllung zu betreibenden Leuchtmittel ist immer bekannt, welcher Summendiagnosestrom fließen muss, wenn alle entsprechend momentan benötigten Leuchtmittel ordnungsgemäß funktionieren und nicht eines oder mehrere dieser momentan benötigten Leuchtmittel ausgefallen sind.

Werden beispielsweise in obigem Beispiel mit vier verschiedenen Leuchtmitteln momentan alle Leuchtmittel zur Erfüllung einer oder mehrerer Lichtfunktionen einer Kraftfahrzeugleuchte benötigt, so ergibt sich für den Summendiagnosestrom IS: IS=(P1+P2+P3+P4)*IG, wenn alle Leuchtmittel ordnungsgemäß funktionieren.

Werden nur zwei oder drei Leuchtmittel zur Erfüllung einer oder mehrerer momentan benötigter Lichtfunktionen betrieben, so weiß dies das entsprechende Steuergerät durch Einschalten der entsprechenden Stromversorgung für die jeweiligen Leuchtmittel und erwartet von dem mindestens einen momentan nicht zur Erfüllung einer Lichtquelle herangezogenen Leuchtmittel keinen dem Summendiagnosestrom beitragenden Einzeldiagnosestrom.

Nachdem die Potenzen alle unterschiedliche Werte aufweisen und deren Summen für jede beliebige Kombination voneinander abweichen, kann anhand des Summendiagnosestroms eindeutig auf die jeweils ordnungsgemäß funktionierenden, einen jeweiligen Gutzustand aufweisenden, und die ausgefallenen, einen jeweiligen Schlechtzustand aufweisenden Leuchtmittel rückgeschlossen werden.

Damit kann der Nachteil des Standes der Technik behoben werden, wonach insbesondere LEDs eine zu geringe Stromaufnahme aufweisen, um anhand ihres Stromverbrauchs überhaupt von einem Steuergerät erkannt werden zu können und wobei bei Leuchtmitteln, die insbesondere ausschließlich LEDs als Lichtquellen verwenden, häufig Blindwiderstände verbaut werden müssen, die einen bestimmten Strom verbrauchen, um eine Erkennung durch ein Steuergerät zu ermöglichen. Dieser Strom kann nunmehr zumindest zum Teil auf sinnvolle Art und Weise in Form von vorzugsweise im Gutzustand zu einem Summendiagnosestrom aufaddierten Einzeldiagnoseströmen verwendet werden, um den ordnungsgemäßen Betrieb des jeweiligen Leuchtmittels anzuzeigen bzw. mitzuteilen.

Eine vorteilhafte Ausgestaltung des Verfahrens sieht vor, auch der Diagnoseleitung selbst eine Ausfallerkennung in Form eines eigenen Einzeldiagnosestroms mit einer in ihrer Höhe einer eigenen Potenz PL eines Grundstromstärkeniveaus IG proportionalen Stromstärke in Höhe von PL*I Ampere zuzuordnen, der wiederum einen Teil des Summendiagnosestroms bilden kann.

Der Diagnoseleitung selbst kann ein Einzeldiagnosestrom mit einer in ihrer Höhe beispielsweise einer nullten Potenz P0 von zwei, entsprechend zwei hoch null, i.e. eins, proportionalen Stromstärke eines Grundstromstärkeniveaus IG zugeordnet sein, entsprechend beispielsweise einer Stromstärke des Einzeldiagnosestroms ausgehend von einem Grundstromniveau IG in Höhe von 1*IG Ampere. Empfängt ein Steuersignal demnach einen Summendiagnosestrom mit einer Stromstärke, deren Höhe einem ungeraden Verhältnis des Grundstromniveaus IG proportional ist, so ist direkt ersichtlich, dass die Diagnoseleitung intakt ist.

Der Strom der der Diagnoseleitung zugeordneten Ausfallerkennung kann beispielsweise bei eingeschalteter Zündung eines Kraftfahrzeugs fließen. Dadurch wird eine intakte oder eine defekte Diagnoseleitung erkannt, auch wenn kein Leuchtmittel momentan betrieben wird.

Der Einzeldiagnosestrom der der Diagnoseleitung zugeordneten Ausfallerkennung fließt vorzugsweise auch dann als Teil des Summendiagnosestroms, wenn ein oder mehrere Leuchtmittel zur Erfüllung einer oder mehrerer momentan benötigten Lichtfunktionen der Kraftfahrzeugleuchte betrieben werden. Sind alle Leuchtmittel der momentan benötigten Lichtfunktionen ausgefallen, fließt der Einzeldiagnosestrom der der Diagnoseleitung zugeordneten Ausfallerkennung als einziger Teil des Summendiagnosestroms. Damit und unter Kenntnis, dass ein oder mehrere Leuchtmittel momentan betrieben sein sollten, um die momentan benötigte eine oder mehrere Lichtfunktionen zu erfüllen, ist für das Steuergerät klar ersichtlich, dass die Diagnoseleitung intakt, aber das oder die zur Erfüllung der mindestens einen momentan benötigten Lichtfunktion vorgesehenen Leuchtmittel defekt sind.

Werden beispielsweise wie in obigem Beispiel mit vier verschiedenen Leuchtmitteln momentan alle Leuchtmittel zur Erfüllung einer oder mehrerer Lichtfunktionen einer Kraftfahrzeugleuchte benötigt, so ergibt sich unter Berücksichtigung des Einzeldiagnosestroms für die Diagnoseleitung der Summendiagnosestrom IS zu: IS=(PL+P1+P2+P3+P4)*IG, wenn alle Leuchtmittel ordnungsgemäß funktionieren.

Nachdem die Potenz PL, welcher die Stromstärke des Einzeldiagnosestroms der Diagnoseleitung zum Grundstromstärkeniveau IG proportional ist, vorzugsweise den Wert eins hat, zeigt das ungerade Proportionalitätsverhältnis das Funktionieren der Diagnoseleitung mit an.

Wird momentan keine Lichtfunktion benötigt entspricht der Summenstrom IS vorzugsweise dem Wert IS=PL*IG.

Werden nur zwei oder drei Leuchtmittel zur Erfüllung einer oder mehrerer momentan benötigter Lichtfunktionen betrieben, so weiß dies das entsprechende Steuergerät durch Einschalten der entsprechenden Stromversorgung für die jeweiligen Leuchtmittel und erwartet von dem mindestens einen momentan nicht zur Erfüllung einer Lichtquelle herangezogenen Leuchtmittel keinen dem Summediagnosestrom beitragenden Einzeldiagnosestrom.

Nachdem die Potenzen der Einzeldiagnoseströme der Ausfallerkennungen der Leuchtmittel und der Diagnoseleitung alle unterschiedliche Werte aufweisen und deren Summen für jede beliebige Kombination voneinander abweichen, kann anhand des Summendiagnosestroms eindeutig auf die jeweils ordnungsgemäß funktionierenden und die ausgefallenen Leuchtmittel sowie Funktion oder Defekt der Diagnoseleitung rückgeschlossen werden.

Grundsätzlich ist denkbar, dass der Einzeldiagnosestrom der der Diagnoseleitung zugeordneten Ausfallerkennung nur dann fließt, wenn keine Lichtfunktion momentan benötigt wird. Dies erlaubt die Erkennung der intakten Diagnoseleitung in ausgeschaltetem Zustand aller Leuchtmittel und verhindert einen höheren Stromverbrauch bei einer oder mehreren momentan benötigten Lichtfunktionen entsprechend einem oder mehreren eingeschalteten Leuchtmitteln.

Wichtig ist hervorzuheben, dass die Diagnoseleitung keine Ausfallerkennung wie für ein Leuchtmittel erforderlich bedarf. Letztendlich genügt es, entweder ab Einschalten der Zündung eines Kraftfahrzeugs, oder - einhergehend mit einem geringeren Stromverbrauch - ab Einschalten eines zur Erfüllung einer momentan benötigten Lichtfunktion vorgesehenen Leuchtmittels den der Diagnoseleitung zugeordneten Einzeldiagnosestrom als alleinigen Bestandteil oder als Teil des Summendiagnosestroms fließen zu lassen, um das Steuergerät über den Zustand der Diagnoseleitung in Kenntnis zu setzen.

Dadurch wird der Nachteil des Standes der Technik behoben, wonach bislang die Übertragung eines Diagnosesignals bei erfasstem Ausfall oder bei erfasstem Sollbetrieb eines Leuchtmittels nicht sicherstellt, dass der Zustand des Leuchtmittels tatsächlich demjenigen Zustand entspricht, den das Steuergerät anhand des Empfangs oder Nichtempfangs des Diagnosesignals annimmt, da beispielsweise eine Unterbrechung der Diagnoseleitung zu einer fehlerhaften Annahme führen kann.

Eine vorteilhafte Ausgestaltung des Verfahrens sieht vor, dass die Ausfallerkennungen innerhalb der Kraftfahrzeugleuchte jeweils eigene Ausfallerkennungssignale an eine Sammelstelle innerhalb der Kraftfahrzeugleuchte senden. Dabei kann es sich bei den Ausfallerkennungssignalen wahlweise um Gutsignale, welche bei Vorhandensein die ordnungsgemäße Funktion eines Leuchtmittels anzeigen und bei Nichtvorhandensein einen Ausfall bzw. den Nichtbetrieb einer oder mehrerer Lichtquellen des Leuchtmittels kenntlich machen, oder um Schlechtsignale handeln, welche nur bei Ausfall eines Leuchtmittels auftreten. Entsprechend der vorhandenen oder nicht vorhandenen Ausfallerkennungssignale wird von der Sammelstelle einen Summendiagnosestrom erzeugt, das beispielsweise via einer Diagnoseschnittstelle an eine Diagnoseleitung ausgegeben wird, die mit einem Steuergerät eines Kraftfahrzeugs verbunden sein kann. Jedem Ausfallerkennungssignal wird dabei eine entsprechende Potenz zugeordnet, so dass beispielsweise bei Vorhandensein aller Ausfallerkennungssignale alle Potenzen aufaddiert und mit dem Grundstromstärkeniveau IG zum Summendiagnosestrom IS multipliziert werden, entsprechend bei beispielhaft vier jeweils mit einer Ausfallerkennung versehenen Leuchtmitteln: IS=(P1+P2+P3+P4)*IG ohne Einzeldiagnosestrom für die Diagnoseleitung, oder entsprechend IS=(PL+P1+P2+P3+P4)*IG mit Einzeldiagnosestrom für die Diagnoseleitung.

Eine alternative Ausgestaltung des Verfahrens sieht vor, dass jede Ausfallerkennung innerhalb der Kraftfahrzeugleuchte einen Einzeldiagnosestrom an eine Sammelstelle übermittelt, welche zusammengeführt und als Summendiagnosestrom beispielsweise via einer Diagnoseschnittstelle an eine Diagnoseleitung ausgegeben wird, die mit einem Steuergerät eines Kraftfahrzeugs verbunden sein kann. Hierbei werden bei Vorhandensein aller Einzeldiagnoseströme aller Ausfallerkennungen die Einzeldiagnoseströme einfach zum Summendiagnosestrom IS summiert, entsprechend bei beispielhaft vier jeweils mit einer Ausfallerkennung versehenen Leuchtmitteln : IS=P1*IG+P2*IG+P3*IG+P4*IG ohne Einzeldiagnosestrom für die Diagnoseleitung, oder entsprechend IS=PL*IG+P1*IG+P2*IG+P3*IG+P4*IG mit Einzeldiagnosestrom für die Diagnoseleitung. Auch hierbei kann es sich wahlweise um Gutsignale oder um Schlechtsignale handeln.

Das Verfahren kann demnach vorsehen, in einem ersten Verfahrensschritt festzustellen, welche Leuchtmittel zur Erfüllung einer oder mehrerer momentan benötigter Lichtfunktionen zu betreiben sind. Diese Feststellung kann beispielsweise anhand der beispielsweise seitens des Kraftfahrzeugs geschalteten Stromversorgungen für die einzelnen Leuchtmittel erfolgen.

Anschließend wird in einem zweiten Verfahrensschritt anhand der Ausfallerkennungen der zur Erfüllung einer oder mehrerer momentan benötigter Lichtfunktionen betriebenen Leuchtmittel deren jeweiliger Zustand ermittelt. Dabei kann jedes Leuchtmittel einen Gutzustand aufweisen, der die ordnungsgemäße Funktion des jeweiligen Leuchtmittels widerspiegelt, sowie einen Schlechtzustand, bei dem die Funktion des jeweiligen Leuchtmittels durch Ausfall einer oder mehrerer Lichtquellen des Leuchtmittels eingeschränkt ist oder das Leuchtmittel ausgefallen ist.

In einem dritten Verfahrensschritt sieht das Verfahren vor, vorzugsweise jedem Gutzustand, alternativ jedoch auch denkbar jedem Schlechtzustand einen Einzeldiagnosestrom zuzuordnen, dessen Stromstärke ausgehend von einem voreingestellten Grundstromstärkeniveau IG einer für jedes Leuchtmittel individuellen Potenz PI einer Potenzreihe proportional ist. Die individuellen Potenzen der Potenzreihe sind dabei für verschiedene, jeweils einem Leuchtmittel zugeordnete Ausfallerkennungen unterschiedlich.

Dabei wird nur denjenigen Leuchtmitteln ein Einzeldiagnosestrom zugeordnet, die zur Erfüllung einer oder mehrerer momentan benötigten Lichtfunktionen der Kraftfahrzeugleuchte momentan benötigt werden.

Die Zuordnung ist dabei bevorzugt fix, wobei jedem Leuchtmittel ein Einzeldiagnosestrom entsprechender Stromstärke zugeordnet bleibt, auch wenn ein Leuchtmittel momentan nicht betrieben wird und dessen Zustand damit momentan keiner Erfassung unterliegt.

In einem vierten Verfahrensschritt sieht das Verfahren vor, einen Summendiagnosestrom zu erzeugen und via einer Diagnoseleitung auszugeben, dessen Stromstärke der Summe der Stromstärken aller den erfassten Zuständen der zur Erfüllung der momentan benötigten Lichtfunktionen der Kraftfahrzeugleuchte vorgesehenen Leuchtmitteln zugeordneten Einzeldiagnoseströmen entspricht.

In einem fünften Verfahrensschritt kann eine mit der Diagnoseleitung verbundene Auswerteeinrichtung, beispielsweise ein mit der Diagnoseleitung verbundenes Steuergerät eines Kraftfahrzeugs, anhand der Höhe der Stromstärke des Summendiagnosestroms die Zustände aller zur Erfüllung der momentan benötigten Lichtfunktionen der Kraftfahrzeugleuchte vorgesehenen Leuchtmittel exakt bestimmen und zuordnen.

Ein optionaler Verfahrensschritt kann vorsehen, der Diagnoseleitung ebenfalls einen Einzeldiagnosestrom zuzuordnen, der ebenfalls ausgehend vom voreingestellten Grundstromstärkeniveau IG einer individuellen Potenz einer Potenzreihe proportional ist. Vorzugsweise handelt es sich hierbei um die nullte Potenz und damit um eine direkte Proportionalität zum Grundstromstärkeniveau IG, bei dem die Stromstärke IL des der Diagnoseleitung zugeordneten Einzeldiagnosestromn dem Grundstromstärkeniveau IG entspricht.

Um den ordnungsgemäßen Zustand der Diagnoseleitung anzuzeigen, kann dieser der Diagnoseleitung zugeordnete Einzeldiagnosestrom beispielsweise fließen, wenn keine Lichtfunktion momentan benötigt wird.

Ein zweiter Gegenstand der Erfindung betrifft eine zur Durchführung eines zuvor beschriebenen Verfahrens geeignete Kraftfahrzeugleuchte mit mehreren, zur Erfüllung einer oder mehrerer Lichtfunktionen vorgesehenen Leuchtmitteln. Mindestens zwei der Leuchtmittel der Kraftfahrzeugleuchte sind mit einer Ausfallerkennung beispielsweise in Form einer Steuerschaltung für eine oder mehrere Lichtquellen des jeweiligen Leuchtmittels ausgestattet.

Eine Ausfallerkennung kann dabei beispielsweise durch eine Steuerschaltung verwirklicht sein, wie sie beispielsweise durch EP 2 247 161 A1 bekannt ist.

Die Kraftfahrzeugleuchte verfügt darüber hinaus über einen beispielsweise als eine Diagnoseschnittstelle ausgeführten Anschluss für eine Diagnoseleitung, via welcher Diagnoseleitung ein Diagnosesignal ausgegeben wird, welchem eindeutig die Funktion oder die Nichtfunktion zumindest desjenigen oder derjenigen mit einer Ausfallerkennung ausgestatteter Leuchtmittel der Kraftfahrzeugleuchte entnehmbar ist, welche zur Erfüllung der einen oder mehreren momentan benötigten Lichtfunktionen der Kraftfahrzeugleuchte zu betreiben sind, und welches Diagnosesignal eindeutig ein oder mehrere der zur Erfüllung der einen oder mehreren momentan benötigten Lichtfunktionen der Kraftfahrzeugleuchte zu betreibenden Leuchtmittel zu identifizieren erlaubt, deren Funktion durch Ausfall einer oder mehrerer ihrer jeweiligen Lichtquellen eingeschränkt oder nicht möglich ist.

Die Kraftfahrzeugleuchte verfügt über Zuordnungsmittel, die jeder Ausfallerkennung einen eindeutige Einzeldiagnosestrom in Höhe einer solchen Stromstärke zuordnen, dass die Summe beliebiger unterschiedlicher Kombinationen von Einzeldiagnoseströmen Summendiagnoseströme verschiedener Stromstärke zur Folge haben, die wiederum eine eindeutige Identifikation von anhand der Ausfallerkennungen ermittelter, ordnungsgemäß funktionierender Leuchtmittel und eingeschränkt funktionierender und/oder ausgefallener Leuchtmittel zulassen.

Diese Zuordnungsmittel verfügen über einen Ausgang, der mit dem Anschluss für die Diagnoseleitung verbunden ist. Ferner verfügen diese Zuordnungsmittel über mehrere mit den Ausfallerkennungen der entsprechend ausgestatteten Leuchtmittel verbundene Eingänge, wobei je ein Eingang mir je einer Ausfallerkennung eines Leuchtmittels verbunden ist.

Die Zuordnungsmittel können durch eine Stromsummierungsschaltung verwirklicht sein. Dabei erzeugt jede Ausfallerkennung ihren eigenen Einzeldiagnosestrom, wobei dann von der Stromsummierungsschaltung die Einzeldiagnoseströme der einzelnen Ausfallerkennungen zum Summendiagnosestrom addiert werden.

Alternativ können die Zuordnungsmittel durch eine Schaltungsanordnung verwirklicht sein, welche jedem an einem Eingang eintreffenden Signal einer Ausfallerkennung einen bestimmten Einzeldiagnosestrom zuordnet und anschließend die Einzeldiagnoseströme zum Summendiagnosestrom addiert.

Um einen erfassten Ausfall eines Leuchtmittels einer Kraftfahrzeugleuchte einem Steuergerät eines Kraftfahrzeugs mitzuteilen, ist hierbei lediglich eine Diagnoseleitung notwendig, über welche vermittels eines erfindungsgemäßen Diagnosesignals ein erfasster Ausfall dem Steuergerät mitgeteilt wird.

Die Kraftfahrzeugleuchte kann über eine Diagnoseschnittstelle verfügen, an welche die Diagnoseleitung angeschlossen ist oder anschließbar ist.

Zusätzlich kann die Kraftfahrzeugleuchte Mittel zur Ausfallerkennung der Diagnoseleitung umfassen. Diese Mittel zur Ausfallerkennung können einen oder mehrere beispielsweise in eine zuvor erwähnte Stromsummierungsschaltung oder in eine zuvor erwähnte Schaltungsanordnung eingebrachte Schaltkreise umfassen, welche einen der Diagnoseleitung zugeordneten Einzeldiagnosestrom mit einer Stromstärke in solcher Höhe erzeugen, welche in beliebiger unterschiedlicher Kombinationen mit keinem oder einem oder mehreren den Ausfallerkennungen zugeordneten Einzeldiagnoseströmen Summendiagnoseströme verschiedener Stromstärke zur Folge hat, die wiederum eine eindeutige Identifikation von anhand der Ausfallerkennungen ermittelter, ordnungsgemäß funktionierender Leuchtmittel und eingeschränkt funktionierender und/oder ausgefallener Leuchtmittel und/oder einer ordnungsgemäß verbundenen Diagnoseleitung zulässt.

Kommt dieser der Diagnoseleitung zugeordnete Einzeldiagnosestrom am Ende der Diagnoseleitung beispielsweise bei ausgeschalteten Leuchtmitteln bei einem Steuergerät eines Kraftfahrzeugs an, erlaubt dies den unmittelbaren Rückschluss, dass die Diagnoseleitung intakt ist.

Bei mindestens einem zur Erfüllung wenigstens einer momentan benötigten Lichtfunktion vorgesehenen, eingeschalteten Leuchtmittel und im Falle der Übertragung eines Summendiagnosestroms aus einem oder mehreren, den Leuchtmitteln zugeordneten Einzeldiagnoseströmen im Gutzustand von Leuchtmitteln, zeigt der Empfang eines ausschließlich dem der Diagnoseleitung zugeordneten Einzeldiagnosestrom entsprechendes Summendiagnosestroms am Ende der Diagnoseleitung an, dass die Diagnoseleitung intakt ist und das oder die zur Erfüllung einer oder mehrerer momentan benötigten Lichtfunktionen vorgesehen Leuchtmittel jeweils Schlechtzustand aufweisen. Entsprechend zeigt der Empfang eines Summendiagnosestroms am Ende der Diagnoseleitung mit einer Stromstärke in einer Höhe, die sich nur in einer Kombination eines oder mehrerer Einzeldiagnoseströme unter Beitrag des der Diagnoseleitung zugeordneten Einzeldiagnosestroms ergibt, an, dass die Diagnoseleitung intakt ist, und durch Abwesenheit des jeweiligen Beitrags des entsprechenden Einzeldiagnosestroms zur Summe des Summendiagnosestroms, welches eine oder welche mehrere zur Erfüllung einer oder mehrerer momentan benötigten Lichtfunktionen vorgesehen Leuchtmittel Schlechtzustand aufweisen. Kommt ein Summendiagnosestrom mit einer Stromstärke in Summe der Einzeldiagnoseströme aller zur Erfüllung der momentan benötigten einen oder mehreren Lichtfunktionen vorgesehenen Leuchtmittel zuzüglich des der Diagnoseleitung zugeordneten Einzeldiagnosestroms an, zeigt dies an, dass alles intakt ist und alle zur Erfüllung einer oder mehrerer momentan benötigten Lichtfunktionen vorgesehen Leuchtmittel jeweils Gutzustand aufweisen.

Bei mindestens einem zur Erfüllung wenigstens einer momentan benötigten Lichtfunktion vorgesehenen, eingeschalteten Leuchtmittel und im Falle der Übertragung eines Summendiagnosestroms aus einem oder mehreren, den Leuchtmitteln zugeordneten Einzeldiagnoseströmen im Schlechtzustand von Leuchtmitteln, zeigt der Empfang eines ausschließlich dem der Diagnoseleitung zugeordneten Einzeldiagnosestrom entsprechendes Summendiagnosestroms am Ende der Diagnoseleitung an, dass die Diagnoseleitung intakt ist und das oder die zur Erfüllung einer oder mehrerer momentan benötigten Lichtfunktionen vorgesehen Leuchtmittel jeweils Gutzustand aufweisen. Entsprechend zeigt der Empfang eines Summendiagnosestroms am Ende der Diagnoseleitung mit einer Stromstärke in einer Höhe, die sich nur in einer Kombination eines oder mehrerer Einzeldiagnoseströme unter Beitrag des der Diagnoseleitung zugeordneten Einzeldiagnosestroms ergibt, an, dass die Diagnoseleitung intakt ist und welches eine oder welche mehrere zur Erfüllung einer oder mehrerer momentan benötigten Lichtfunktionen vorgesehen Leuchtmittel Schlechtzustand aufweisen.

Die Kraftfahrzeugleuchte kann einen von einem Leuchtengehäuse und einer Lichtscheibe umschlossenen Leuchteninnenraum und mindestens zwei in dem Leuchteninnenraum untergebrachte und mit jeweils einer Ausfallerkennung ausgestattete Leuchtmittel zur Erfüllung mindestens einer Lichtfunktion der Kraftfahrzeugleuchte umfassen. Die Leuchtmittel weisen jeweils wenigstens eine Lichtquelle auf.

In dem Leuchteninnenraum kann mindestens ein Reflektor angeordnet sein. Der mindestens eine Reflektor ist wenigstens einer Lichtquelle eines Leuchtmittels zugeordnet. Der mindestens eine Reflektor lenkt das von der wenigstens einen Lichtquelle abgestrahlte Licht in eine Hauptlichtabstrahlrichtung um und verteilt das Licht in einem Raumwinkelbereich entsprechend einer vorgegebenen Lichtverteilung der von dem entsprechenden Leuchtmittel, zu dem die Lichtquelle gehört, zu erfüllenden Lichtfunktion, um diese Hauptlichtabstrahlrichtung.

Die Lichtquelle und der Reflektor sind dabei zur Erfüllung der vorgegebenen Lichtverteilung aufeinander abgestimmt.

Die Kraftfahrzeugleuchte kann in mehrere Kammern unterteilt sein, von denen mehrere Kammern gleiche oder unterschiedliche Lichtfunktionen zu erfüllen vorgesehen sind.

Dabei können eine oder mehrere Kammern mit einem eigenen Leuchtmittel mit einer oder mehreren Lichtquellen ausgestattet sein, und/oder mehrere Kammern jeweils mit einer oder mehreren Lichtquellen eines gemeinsamen Leuchtmittels ausgestattet sein, welche Lichtquellen entsprechend gleichzeitig betrieben werden, und/oder eine oder mehrere Kammern einen oder mehrere, der mindestens einen Lichtquelle der jeweiligen Kammer zugeordnete Reflektoren sowie eine oder mehrere entsprechend ausgestaltete und sich an eine Vorderkante wenigstens eines in der Kammer beherbergten Reflektors anschließende und sich zur Lichtscheibe hin erstreckende Wandflächen umfassen.

Eine oder mehrere Lichtquellen zumindest eines Leuchtmittels der Kraftfahrzeugleuchte kann mindestens eine LED umfassen oder als LED ausgebildet sein.

Durch Verwendung einer zumindest nahezu punktförmigen Lichtquelle, wie sie durch eine LED verwirklicht ist, lässt sich die dem Quotienten des einer für eine Lichtfunktion beispielsweise gesetzlich vorgegebene Lichtverteilung beitragend aus der Kraftfahrzeugleuchte austretenden Lichts zum von allen Lichtquellen eines oder mehrerer zur Erfüllung der jeweiligen Lichtfunktion der Kraftfahrzeugleuchte vorgesehener Leuchtmittel ausgestrahlten Licht entsprechende optische Güte steigern, weil eine punktförmige Lichtquelle eine optimale Auslegung des gesamten Strahlengangs von der Lichtentstehung bis zum Verlassen der Kraftfahrzeugleuchte durch die Lichtscheibe hindurch ermöglicht. Hierdurch kann das unerwünschte Austreten von Licht in anderen, als den durch eine vorgegebene Lichtverteilung vorgesehenen Raumwinkelbereichen aus der Kraftfahrzeugleuchte, das so genannte Streulicht, zumindest annähernd vollständig vermieden werden, unabhängig davon, welcher Typ LED als Lichtquelle verwendet wird.

Dabei unterscheiden sich verschiedene Typen von LEDs im Wesentlichen durch deren elektrische Kontaktierung sowie dem Vorhandensein einer Kapselung und/oder einer Primäroptik, wie anhand der nachfolgenden Ausführungen deutlich wird.

Eine LED umfasst neben dem bereits Eingangs erwähnten mindestens einen LED-Chip auch mindestens ein Kontaktmittel zur elektrischen Kontaktierung des LED-Chips. Üblicherweise verfügt jede Leuchtdiode über einen Bonddraht je LED-Chip, welcher je einen LED-Chip elektrisch kontaktiert. Dieser Bonddraht bildet ein erstes Kontaktmittel für den LED-Chip der LED. Der Bonddraht kann mit einem ersten elektrischen Anschluss verbunden sein, welcher zur elektrischen Kontaktierung der LED 50 beispielsweise mit einer ersten Leiterbahn eines Leuchtmittelträgers vorgesehen sein kann. Ein zweites Kontaktmittel für den LED-Chip der LED bildet der LED-Chip selbst. Zur elektrischen Kontaktierung kann der LED-Chip mit einem zweiten elektrischen Anschluss verbunden sein, welcher zur elektrischen Kontaktierung der LED beispielsweise mit einer zweiten Leiterbahn eines Leuchtmittelträgers vorgesehen sein kann.

Die LED kann darüber hinaus einen den LED-Chip unmittelbar umgebenden Primärreflektor aufweisen. Dieser Primärreflektor kann beispielsweise durch Wandungen einer den LED-Chip umgebenden Ausnehmung und/oder durch einen Napf gebildet sein, in dem der LED-Chip angeordnet ist. Der Napf kann mit dem erwähnten zweiten Anschluss verbunden sein, diesen bilden oder umfassen oder von diesem umfasst werden.

Bei speziellen Ausführungen von LEDs können einzelne oder alle Kontaktmittel selbst die elektrischen Anschlüsse bilden, wie nachfolgend zu den verschiedenen Kontaktierungsmöglichkeiten von LEDs ausgeführt.

Bekannt sind LEDs zur Durchsteckmontage (THT; Through Hole Technology), oberflächenmontierbare (SMD; Surface Mounted Device) LEDs und LEDs, bei denen der LED-Chip in Nacktmontagetechnik (COB; Chip On Board) direkt auf den Leuchtmittelträger gebondet wird.

THT-LEDs sind der gängig bekannte Typ LEDs. Sie werden auch als bedrahtete LEDs bezeichnet, da sie aus einer zumindest in einer gewünschten Abstrahlrichtung transparenten Kapselung, z.B. in Form einer Umspritzung oder eines Vergusses bestehen, welche einen den LED-Chip mit einem ersten elektrischen Anschluss, beispielsweise in Form eines Anodenanschlusses verbindenden Bonddraht und den mit einem zweiten elektrischen Anschluss, beispielsweise in Form eines Kathodenanschlusses, verbundenen LED-Chip einschließt. Aus der Kapselung ragen nur die auch als Beinchen bezeichneten Drähte des ersten elektrischen Anschlusses und des zweiten elektrischen Anschlusses als die Anoden- und Kathodenanschlüsse der THT-LED. Der beispielsweise als Kathodenanschluss ausgeführte zweite elektrische Anschluss kann hierbei mit einem oben erwähnten Napf versehen sein, in dem der LED-Chip angeordnet ist. Der Bonddraht führt vom beispielsweise als Anodenanschluss ausgeführten ersten Anschluss von außerhalb des Napfs kommend zum LED-Chip.

SMD-LEDs bestehen aus einem Leadframe mit wenigstens einer Bestückungsfläche für mindestens einen LED-Chip sowie elektrischen Anschlussflächen. Das Leadframe ist von einem Kunststoffkörper mit zumindest einer die wenigstens eine Bestückungsfläche freihaltenden Ausnehmung teilweise umspritzt. Die elektrischen Anschlussflächen des Leadframes sind hierbei als die elektrischen Anschlüsse der SMD-LED zur späteren Oberflächenmontage ebenfalls freigehalten. Der mindestens eine LED-Chip ist am Grund der zumindest einen zur wenigstens einen Bestückungsfläche reichenden Ausnehmung angeordnet und elektrisch kontaktiert. Dabei ist der LED-Chip auf einer mit wenigstens einer ersten elektrischen Anschlussfläche verbundenen ersten Partie des Leadframes angeordnet. Ein Bonddraht verbindet den LED-Chip mit einer zweiten Partie des Leadframes, die wiederum mit wenigstens einer zweiten elektrischen Anschlussfläche verbunden ist. Die an ihrem Grund zur Bestückungsfläche reichende Ausnehmung kann reflektorartig ausgestaltet sein. Dabei bilden die Wandungen der Ausnehmung den oben erwähnten Primärreflektor. Hierbei können die Wandungen reflektierend beschichtet sein.

COB-LEDs bestehen aus einem direkt auf einem Leuchtmittelträger anzuordnenden, ungehäusten LED-Chip und einem Bonddraht. Die Rückseite des LED-Chips bildet dabei den ersten elektrischen Anschluss der COB-LED. Zur elektrischen Kontaktierung wird der LED-Chip auf seiner Rückseite direkt mit einer ersten Leiterbahn eines Leuchtmittelträgers z.B. durch Löten oder Schweißen elektrisch verbunden. Der den zweiten elektrischen Anschluss der COB-LED bildende Bonddraht wird mit einer zweiten Leiterbahn des Leuchtmittelträgers ebenfalls z.B. durch Löten oder Schweißen elektrisch verbunden.

Der Vollständigkeit halber sei ergänzend erwähnt, dass auch andere Kontaktierungen wie z.B. der so genannte Flip-Chip-Aufbau möglich sind, bei dem die Kontaktmittel des LED-Chips direkt mit einem kontaktierten Substrat verbunden sind. In diesen Fällen wird kein Bonddraht verwendet.

Die Kraftfahrzeugleuchte kann:
- als eine Heckleuchte, oder
- als ein Scheinwerfer, oder
- als eine Tagfahrleuchte, oder
- als ein Nebelscheinwerfer und/oder eine Abbiegeleuchte, oder
- als eine hoch gesetzte dritte Bremsleuchte, oder
- als eine Nebelschlussleuchte
für ein Kraftfahrzeug ausgebildet sein. Alternativ oder zusätzlich kann die Kraftfahrzeugleuchte zur Erfüllung zumindest:
- einer Abblendlichtfunktion, und/oder
- einer Tagfahrlichtfunktion, und/oder
- einer Abbiegelichtfunktion, und/oder
- einer Nebelscheinwerferlichtfunktion, und/oder
- einer Nebelschlusslichtfunktion, und/oder
- einer Bremslichtfunktion
ausgeführt sein.

Es ist ersichtlich, dass die Erfindung verwirklicht sein kann, indem jeder beispielsweise durch LEDs als Lichtquellen eines oder mehrerer Leuchtmittel verwirklichten Lichtfunktion der Kraftfahrzeugleuchte ein Stromwert entsprechend einem Einzeldiagnosestrom zugeordnet wird. Die Stromwerte sind eindeutig gewichtet, beispielsweise nach dem Binärnummersystem. So kann beispielsweise:
- einer Schlusslichtfunktion bzw. einer dem oder den zu deren Erfüllung vorgesehenen Leuchtmitteln zugeordneten Ausfallerkennung ein Stromwert von 1 mA,
- einer Bremslichtfunktion bzw. einer dem oder den zu deren Erfüllung vorgesehenen Leuchtmitteln zugeordneten Ausfallerkennung ein Stromwert von 2mA,
- einer Wiederholblinklichtfunktion bzw. einer dem oder den zu deren Erfüllung vorgesehenen Leuchtmitteln zugeordneten Ausfallerkennung ein Stromwert von 4mA,
- einer Nebelschlusslichtfunktion bzw. einer dem oder den zu deren Erfüllung vorgesehenen Leuchtmitteln zugeordneten Ausfallerkennung ein Stromwert von 8mA, und
- einer Rückfahrlichtfunktion bzw. einer dem oder den zu deren Erfüllung vorgesehenen Leuchtmitteln zugeordneten Ausfallerkennung ein Stromwert von 16mA

zugeordnet sein. Eine Schaltungsanordnung in der Kraftfahrzeugleuchte addiert die gewichteten Stromwerte, und schickt den sich hieraus ergebenden Summenstrom in Form eines Diagnosesignals durch die Diagnoseleitung beispielsweise zu einem an diese angeschlossenen Steuergerät eines Kraftfahrzeugs zurück. Aus dem Summenstrom kann das Steuergerät die den Lichtfunktionen zugeordneten Leuchtmittel unverwechselbar identifizieren.

Aktiviert ein Fahrer eines Kraftfahrzeugs in obigem Beispiel die Schlusslicht- und die Bremslichtfunktion, so weiß das Steuergerät, dass der Diagnosestrom 1 mA + 2mA = 3mA sein muss. Wenn alles ordentlich funktioniert, muss durch die Diagnoseleitung ein Summendiagnosestrom mit einer Stromstärke von 3mA zum Steuergerät fließen. Wenn das zur Erfüllung der Schlusslichtfunktion vorgesehene Leuchtmittel ausgefallen wäre, würde nur 2mA Strom ankommen.

Um das durch den Summenstrom gebildete Diagnosesignal zu erzeugen, gibt es mehrere Möglichkeiten. Entweder verfügt jede Lichtfunktion bzw. jedes einer Lichtfunktion zugeordnete Leuchtmittel über eine eigene Einzeldiagnosestromquelle, wobei die Addition der Einzeldiagnoseströme gemäß dem ersten Kirchhoffschen Gesetz in der Verkabelung erfolgt, oder der passende Einzeldiagnosestrom wird abhängig von den beispielsweise via kraftfahrzeugleuchteninterner Leitungen jeweils mit einer Sammelstelle verbundenen Ausfallerkennungen der einzelnen Lichtquellen ausgegebenen Meldungen erzeugt.

Vorteile gegenüber dem Stand der Technik ergeben sich unter Anderem dadurch, dass vermittels nur einer einzigen Diagnoseleitung durch einfaches Aufaddieren von den einzelnen zur Erfüllung einer oder mehrerer Lichtfunktionen vorgesehenen Leuchtmitteln einer Kraftfahrzeugleuchte zugeordneten Strömen vorgegebener Proportionalitäten eine dezidierten Mitteilung des Ausfalls eines bestimmten Leuchtmittels von mehreren, zur Erfüllung unterschiedlicher und/oder gleicher Lichtfunktionen einer Kraftfahrzeugleuchte vorgesehener Leuchtmittel bzw. des Ausfalls einer oder mehrerer Lichtquellen dessen einer oder mehrerer Lichtquellen eines bestimmten Leuchtmittels von mehreren, zur Erfüllung unterschiedlicher und/oder gleicher Lichtfunktionen einer Kraftfahrzeugleuchte vorgesehener Leuchtmittel möglich ist.

Weitere Vorteile gegenüber dem Stand der Technik ergeben sich durch die Möglichkeit einer Rationalisierung und Vereinfachung der Anzahl von Diagnoseschnittstellen in Kraftfahrzeugen.

Ein zusätzlicher Vorteil gegenüber dem Stand der Technik ist, dass zur Erzeugung eines Diagnosesignals in Form eines Diagnosestroms, dessen Stromstärke sich aus der Summe der Stromstärken mehrerer Einzelstromsignale ergibt, beispielsweise keine aufwändigen und damit ausfallträchtigen Schaltungsanodnungen benötigt werden. Eine zur Verwirklichung des erfindungsgemäßen Verfahrens vorgesehene Kraftfahrzeugleuchte kann einfach, kostengünstig, ausfallsicher und damit betriebssicher mit einfachen und kostengünstigen elektronischen Bauteilen bestückt werden, ganz im Gegensatz zu einer beim Stand der Technik denkbaren Aufmodulierung von Signalen oder der Erzeugung digitaler Signale nebst deren Übertragung über eine gemeinsame Diagnoseleitung.

Die vorliegende technische Lösung ermöglicht die Diagnostizierung mehrerer zur Erfüllung einer oder mehrerer Lichtfunktionen vorgesehener Leuchtmittel durch nur eine einzige Diagnoseleitung zwischen Kraftfahrzeugleuchte und Steuergerät. Die Ausfallerkennungselektronik der Kraftfahrzeugleuchte muss die Lichtfunktion bei einem Ausfall eines Leuchtmittels nicht komplett abschalten, sondern sie kann das Steuergerät über den Status der zur Erfüllung einer oder mehrerer Lichtfunktionen vorgesehenen Leuchtmittel via die Diagnoseleitung informieren. Das Steuergerät kann sich selber entscheiden, ob es ein defektes Leuchtmittel abschaltet oder die Stromversorgung bestehen lässt.

Ein weiterer Vorteil ist die Störfestigkeit und der EMV-Verträglichkeit dieser Lösung. Das Stromsignal ist störungsfest und strahlt aufgrund dessen Gleichstromeigenschaft in linearem Betrieb nicht.

Die Verwendung dieser Lösung ermöglicht die Entfernung der zum Stand der Technik erwähnten Dummywiderstände, und so erhöht sich die Effizienz der Ansteuerungselektronik. Der höhere Wirkungsgrad bedeutet weniger Verlustleistung auf den Leuchtmittelträgern. Dies wiederum hat eine kleinere notwendige Oberfläche der Leuchtmittelträger und damit einhergehend einen geringeren Bauraumbedarf zur Folge. In Verbindung mit LEDs als Lichtquellen hat dies auch eine niedrigere LED-Degradation zur Folge, da an Ort und Stelle kein Strom in Dummywiderständen in schädliche Wärme umgewandelt wird.

Die Erfindung wird nachfolgend anhand von in den Zeichnungen dargestellter Ausführungsbeispiele näher erläutert. Darin bezeichnen gleiche Bezugszeichen gleiche oder gleich wirkende Elemente. Der Übersicht halber sind nur Bezugszeichen in den einzelnen Zeichnungen dargestellt, die für die Beschreibung der jeweiligen Zeichnung erforderlich sind. Die Größenverhältnisse der einzelnen Elemente zueinander entsprechen dabei nicht immer den realen Größenverhältnissen, da einige Formen vereinfacht und andere Formen zur besseren Veranschaulichung vergrößert im Verhältnis zu anderen Elementen dargestellt sind. Es zeigen in schematischer Darstellung:
- Fig. 1: eine schematische Ansicht einer erfindungsgemäßen Kraftfahrzeugleuchte gemäß eines ersten Ausführungsbeispiels.
- Fig. 2: eine schematische Ansicht einer erfindungsgemäßen Kraftfahrzeugleuchte gemäß eines zweiten Ausführungsbeispiels.

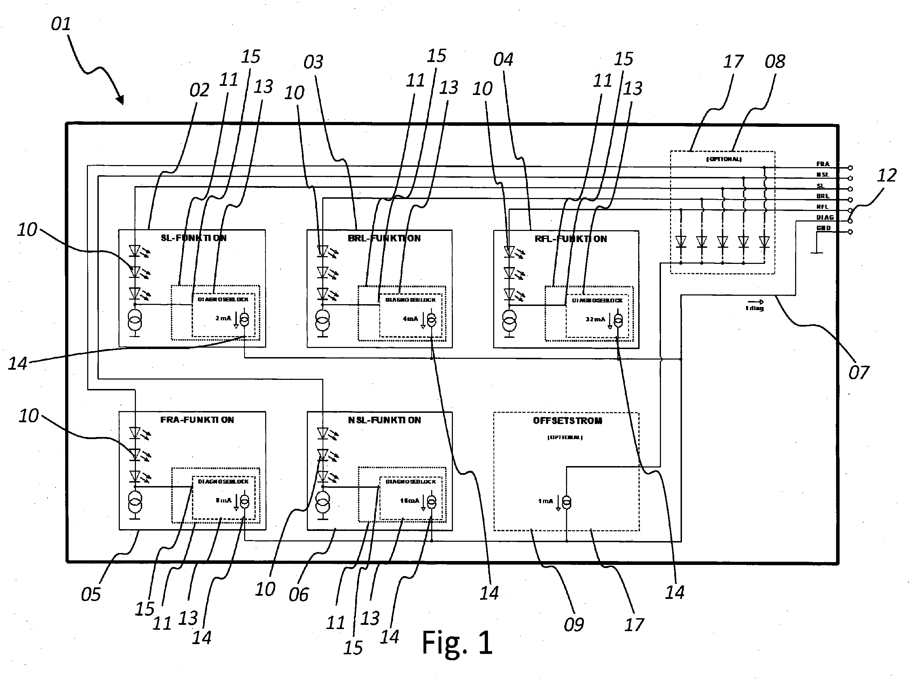

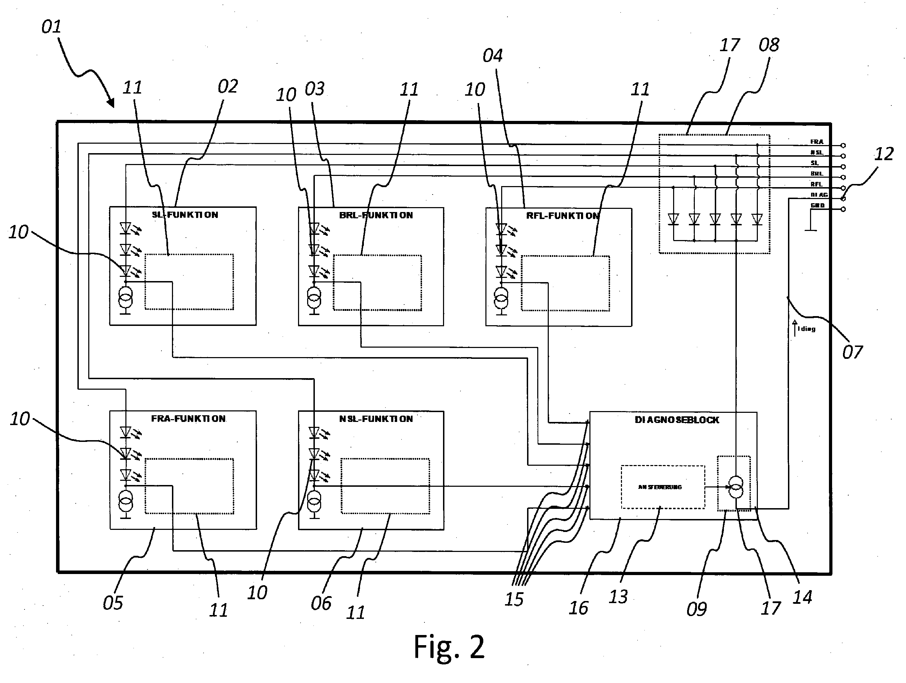

Eine in den Fig. 1 und Fig. 2 ganz oder in Teilen dargestellte Kraftfahrzeugleuchte 01 umfasst mindestens zwei Leuchtmittel 02, 03, 04, 05, 06 zur Erfüllung mindestens einer Lichtfunktion der Kraftfahrzeugleuchte 01. Jedes Leuchtmittel 02, 03, 04, 05, 06 weist wenigstens eine Lichtquelle 10, vorzugsweise einen LED-Strang mit jeweils einer oder mehreren LEDs als Lichtquelle 10 auf.

Von den Leuchtmitteln 02, 03, 04, 05, 06 der Kraftfahrzeugleuchte 01 sind mindestens zwei mit einer Ausfallerkennung 11 beispielsweise in Form einer Steuerschaltung für eine oder mehrere Lichtquellen 10 des jeweiligen Leuchtmittels 02, 03, 04, 05, 06 ausgestattet.

Bei den jeweils mit einer Ausfallerkennung 11 ausgestatteten Leuchtmitteln 02, 03, 04, 05, 06 der in Fig. 1 und in Fig. 2 dargestellten Kraftfahrzeugleuchten handelt es sich um:
- ein zur Erfüllung einer Schlusslichtfunktion vorgesehenes Leuchtmittel 02, und
- ein zur Erfüllung einer Bremslichtfunktion vorgesehenes Leuchtmittel 03, und
- ein zur Erfüllung einer Rückfahrlichtfunktion vorgesehenes Leuchtmittel 04, und
- ein zur Erfüllung einer Widerholblinklichtfunktion vorgesehenes Leuchtmittel 05, und
- ein zur Erfüllung einer Nebelschlusslichtfunktion vorgesehenes Leuchtmittel 06.

Die in Fig. 1 und in Fig. 2 dargestellten Kraftfahrzeugleuchten 01 verfügen außerdem über einen beispielsweise als eine Diagnoseschnittstelle ausgeführten Anschluss 12 für eine Diagnoseleitung 07. Über die Diagnoseleitung 07 wird ein Diagnosesignal Idiag ausgegeben, welchem eindeutig einer ordnungsgemäßen Funktion entsprechende Gutzustände und/oder einer nicht ordnungsgemäßen Funktion entsprechende Schlechtzustände zumindest desjenigen oder derjenigen mit einer Ausfallerkennung 11 ausgestatteter Leuchtmittel 02, 03, 04, 05, 06 der Kraftfahrzeugleuchte 01 entnehmbar sind, welche zur Erfüllung der einen oder mehreren momentan benötigten Lichtfunktionen der Kraftfahrzeugleuchte 01 zu betreiben sind.

Das Diagnosesignal Idiag erlaubt eindeutig ein oder mehrere der zur Erfüllung der einen oder mehreren momentan benötigten Lichtfunktionen der Kraftfahrzeugleuchte 01 zu betreibenden Leuchtmittel 02, 03, 04, 05, 06 zu identifizieren, deren Funktion durch Ausfall einer oder mehrerer ihrer jeweiligen Lichtquellen 10 eingeschränkt oder nicht möglich ist.

Die in Fig. 1 und in Fig. 2 dargestellten Kraftfahrzeugleuchten 01 verfügen darüber hinaus über Zuordnungsmittel 13, die jeder Ausfallerkennung 11 einen eindeutige Einzeldiagnosestrom in Höhe einer solchen Stromstärke zuordnen, dass die Summe beliebiger unterschiedlicher Kombinationen von Einzeldiagnoseströmen Summendiagnoseströme verschiedener Stromstärke zur Folge haben, die als Diagnosesignal Idiag via des Anschlusses 12 für die Diagnoseleitung 07 ausgegeben wiederum eine eindeutige Identifikation von anhand der Ausfallerkennungen 11 ermittelter, ordnungsgemäß funktionierender Leuchtmittel 02, 03, 04, 05, 06 im Gutzustand und eingeschränkt funktionierender und/oder ausgefallener Leuchtmittel 02, 03, 04, 05, 06 im Schlechtzustand zulassen.

Die Zuordnungsmittel 13 verfügen dabei über einen Ausgang 14, der mit dem Anschluss 12 für die Diagnoseleitung 07 verbunden ist. Die Zuordnungsmittel 13 verfügen außerdem über mehrere mit den Ausfallerkennungen 11 der entsprechend ausgestatteten Leuchtmittel 02, 03, 04, 05, 06 verbundene Eingänge 15, von denen je ein Eingang 15 mit je einer Ausfallerkennung 11 eines Leuchtmittels 02, 03, 04, 05, 06 verbunden ist.

Die Kraftfahrzeugleuchte 01 kann einen nicht näher dargestellten, von einem Leuchtengehäuse und einer Lichtscheibe umschlossenen Leuchteninnenraum umfassen.

Eines, mehrere oder alle Leuchtmittel 02, 03, 04, 05, 06 können in dem Leuchteninnenraum beherbergt sein. In dem Leuchteninnenraum kann wenigstens ein zumindest einer Lichtquelle 10 eines Leuchtmittels 02, 03, 04, 05, 06 zugeordneter Reflektor untergebracht sein. Lichtquelle 10 und Reflektor sind dabei zur Erfüllung einer für eine Lichtfunktion vorgegebenen Lichtverteilung aufeinander abgestimmt. Hierzu lenkt der Reflektor das von einer Lichtquelle 10 abgestrahlte Licht in eine Hauptlichtabstrahlrichtung um. Dabei verteilt der Reflektor das Licht entsprechend einer vorgegebenen Lichtverteilung der von dem entsprechenden Leuchtmittel 02, 03, 04, 05, 06, zu dem die Lichtquelle 10 gehört, zu erfüllenden Lichtfunktion um diese Hauptlichtabstrahlrichtung.

Unter Beitrag zur Lichtverteilung kann dabei Licht auch direkt durch die Lichtscheibe nach außen abgestrahlt werden, ohne zuvor vom Reflektor umgelenkt zu werden.

Die Kraftfahrzeugleuchte 01 kann:
- als eine Heckleuchte, oder
- als ein Scheinwerfer, oder
- als eine Tagfahrleuchte, oder
- als ein Nebelscheinwerfer und/oder eine Abbiegeleuchte, oder
- als eine hoch gesetzte dritte Bremsleuchte, oder
- als eine Nebelschlussleuchte
für ein Kraftfahrzeug ausgebildet sein. Alternativ oder zusätzlich kann die Kraftfahrzeugleuchte 01 zur Erfüllung zumindest:
- einer Abblendlichtfunktion, und/oder
- einer Tagfahrlichtfunktion, und/oder
- einer Abbiegelichtfunktion, und/oder
- einer Nebelscheinwerferlichtfunktion, und/oder
- einer Nebelschlusslichtfunktion, und/oder
- einer Bremslichtfunktion, und/oder
- einer Schlusslichtfunktion, und/oder
- einer Begrenzungslichtfunktion, und/oder
- einer als Warn- und/oder Fahrtrichtungsanzeigelichtfunktion dienenden Widerholblinklichtfunktion, und/oder
- einer Rückfahrlichtfunktion
eines Kraftfahrzeugs ausgeführt sein.

Um das Diagnosesignal Idiag in Form eines Summendiagnosestroms zu erzeugen, gibt es mehrere Möglichkeiten. Entweder verfügt jede Lichtfunktion bzw. jedes einer Lichtfunktion zugeordnete Leuchtmittel 02, 03, 04, 05, 06 wie bei der in Fig. 1 dargestellten Kraftfahrzeugleuchte 01 über eine eigene, beispielsweise jeweils durch die Zuordnungsmittel 13 verwirklichte Einzeldiagnosestromquelle, wobei die Addition der Einzeldiagnoseströme gemäß dem ersten Kirchhoffschen Gesetz in der Verkabelung erfolgt, oder der passende Einzeldiagnosestrom wird wie bei der in Fig. 2 dargestellten Kraftfahrzeugleuchte 01 abhängig von den beispielsweise via kraftfahrzeugleuchteninterner Leitungen jeweils mit einer Sammelstelle 16 verbundenen Ausfallerkennungen 11 der einzelnen Leuchtmittel 02, 03, 04, 05, 06 ausgegebenen Meldungen erzeugt.

Die Zuordnungsmittel 13 können demnach wie in Fig. 1 dargestellt eine Stromsummierungsschaltung umfassen oder durch eine solche verwirklicht sein. Dabei erzeugt jede Ausfallerkennung 11 ihren eigenen Einzeldiagnosestrom. Bei den Einzeldiagnoseströmen kann es sich bei der in Fig. 1 dargestellten Kraftfahrzeugleuchte 01 beispielsweise um:
- einen Einzeldiagnosestrom in Höhe von 2mA für das Leuchtmittel 02,
- einen Einzeldiagnosestrom in Höhe von 4mA für das Leuchtmittel 03,
- einen Einzeldiagnosestrom in Höhe von 32mA für das Leuchtmittel 04,
- einen Einzeldiagnosestrom in Höhe von 8mA für das Leuchtmittel 05,
- einen Einzeldiagnosestrom in Höhe von 16mA für das Leuchtmittel 06
handeln. Die Einzeldiagnoseströme der einzelnen Ausfallerkennungen 11 werden von der Stromsummierungsschaltung zum das Diagnosesignal Idiag bildenden Summendiagnosestrom addiert. Die Stromsummierungsschaltung kann dabei durch eine Verbindung des Ausgangs 14 bzw. der Ausgänge 14 der Zuordnungsmittel 13 mit dem Anschluss 12 für die Diagnoseleitung 07 hergestellt sein.

Alternativ können die Zuordnungsmittel 13 wie bei der in Fig. 2 dargestellten Kraftfahrzeugleuchte 01 durch eine Schaltungsanordnung 16 verwirklicht sein, welche jedem an einem Eingang 15 eintreffenden Signal einer Ausfallerkennung 11 einen bestimmten Einzeldiagnosestrom zuordnet und anschließend die Einzeldiagnoseströme zum Summendiagnosestrom addiert.

Die Kraftfahrzeugleuchte 01 kann wie in Fig. 1 und in Fig. 2 dargestellt zusätzlich Mittel 17 zur Ausfallerkennung der Diagnoseleitung 07 umfassen. Die Mittel 17 zur Ausfallerkennung können einen oder mehrere beispielsweise in eine zuvor erwähnte Stromsummierungsschaltung oder in eine zuvor erwähnte Schaltungsanordnung 16 eingebrachte Schaltkreise 08, 09 umfassen, die einen der Diagnoseleitung 07 zugeordneten Einzeldiagnosestrom mit einer Stromstärke in solcher Höhe erzeugen, welche in beliebiger unterschiedlicher Kombinationen mit keinem oder einem oder mehreren den Ausfallerkennungen 11 der Leuchtmittel 02, 03, 04, 05, 06 zugeordneten Einzeldiagnoseströmen Summendiagnoseströme verschiedener Stromstärke zur Folge hat, die wiederum eine eindeutige Identifikation von anhand der Ausfallerkennungen 11 ermittelter, ordnungsgemäß funktionierender Leuchtmittel 02, 03, 04, 05, 06 im Gutzustand und eingeschränkt funktionierender und/oder ausgefallener Leuchtmittel 02, 03, 04, 05, 06 im Schlechtzustand und/oder einer ordnungsgemäß verbundenen Diagnoseleitung 07 zulässt.

Verfügen die Mittel 17 zur Ausfallerkennung der Diagnoseleitung 07 über eine eigene, vom Betrieb eines oder mehrerer Leuchtmittel 02, 03, 04, 05, 06 unabhängige Stromversorgung, so erlaubt dies eine Kontrolle der Diagnoseleitung 07 auch bei ausgeschalteten Leuchtmitteln 02, 03, 04, 05, 06. Kommt hierbei ein der Diagnoseleitung 07 zugeordnete Einzeldiagnosestrom am Ende einer an den Anschluss 12 angeschlossenen Verlängerung der Diagnoseleitung 07 bei ausgeschalteten Leuchtmitteln 02, 03, 04, 05, 06 bei einem Steuergerät eines Kraftfahrzeugs als Diagnosesignal Idiag dienender Summendiagnosestrom an, erlaubt dies den unmittelbaren Rückschluss, dass die Diagnoseleitung 07 nebst deren Verlängerung intakt ist.

Aus Gründen des Stromverbrauchs ist es zweckdienlich, die Mittel 17 zur Ausfallerkennung der Diagnoseleitung 07 wie bei den in Fig. 1 und in Fig. 2 dargestellten Kraftfahrzeugleuchten 01, frei von einer über eine eigene, vom Betrieb eines oder mehrerer Leuchtmittel 02, 03, 04, 05, 06 unabhängigen Stromversorgung auszuführen.

Dies erlaubt die nachfolgend beschriebenen Diagnosemöglichkeiten des Zustands der Diagnoseleitung 07, welche selbstverständlich auch bei eigener Stromversorgung der Mittel 17 zur Ausfallerkennung der Diagnoseleitung 07 bestehen.

Bei mindestens einem zur Erfüllung wenigstens einer momentan benötigten Lichtfünktion vorgesehenen, eingeschalteten Leuchtmittel 02, 03, 04, 05, 06 und im Falle der Übertragung eines Summendiagnosestroms aus einem oder mehreren, den Leuchtmitteln 02, 03, 04, 05, 06 zugeordneten Einzeldiagnoseströmen im Gutzustand von Leuchtmitteln 02, 03, 04, 05, 06, zeigt der Empfang eines ausschließlich dem der Diagnoseleitung 07 zugeordneten Einzeldiagnosestrom entsprechendes und als Diagnosesignal Idiag dienenden Summendiagnosestroms am Ende der Diagnoseleitung 07 an, dass die Diagnoseleitung 07 intakt ist und das oder die zur Erfüllung einer oder mehrerer momentan benötigten Lichtfunktionen vorgesehen Leuchtmittel 02, 03, 04, 05, 06 jeweils Schlechtzustand aufweisen. Entsprechend zeigt der Empfang eines als Diagnosesignal Idiag dienenden Summendiagnosestroms am Ende der Diagnoseleitung 07 mit einer Stromstärke in einer Höhe, die sich nur in einer Kombination eines oder mehrerer Einzeldiagnoseströme unter Beitrag des der Diagnoseleitung 07 zugeordneten Einzeldiagnosestroms ergibt, an, dass die Diagnoseleitung 07 intakt ist, und durch Abwesenheit des jeweiligen Beitrags des entsprechenden Einzeldiagnosestroms zur Summe des Summendiagnosestroms, welches eine oder welche mehrere zur Erfüllung einer oder mehrerer momentan benötigten Lichtfunktionen vorgesehen Leuchtmittel 02, 03, 04, 05, 06 Schlechtzustand aufweisen. Kommt ein Summendiagnosestrom mit einer Stromstärke in Summe der Einzeldiagnoseströme aller zur Erfüllung der momentan benötigten einen oder mehreren Lichtfunktionen vorgesehenen Leuchtmittel 02, 03, 04, 05, 06 zuzüglich des der Diagnoseleitung zugeordneten Einzeldiagnosestroms an, zeigt dies an, dass alles intakt ist und alle zur Erfüllung einer oder mehrerer momentan benötigten Lichtfunktionen vorgesehen Leuchtmittel 02, 03, 04, 05, 06 jeweils Gutzustand aufweisen.

Bei mindestens einem zur Erfüllung wenigstens einer momentan benötigten Lichtfunktion vorgesehenen, eingeschalteten Leuchtmittel 02, 03, 04, 05, 06 und im Falle der Übertragung eines als Diagnosesignal Idiag dienenden Summendiagnosestroms aus einem oder mehreren, den Leuchtmitteln 02, 03, 04, 05, 06 zugeordneten Einzeldiagnoseströmen im Schlechtzustand von Leuchtmitteln 02, 03, 04, 05, 06, zeigt der Empfang eines ausschließlich dem der Diagnoseleitung 07 zugeordneten Einzeldiagnosestrom entsprechendes, als Diagnosesignal Idiag dienenden Summendiagnosestroms am Ende der Diagnoseleitung 07 an, dass die Diagnoseleitung 07 intakt ist und das oder die zur Erfüllung einer oder mehrerer momentan benötigten Lichtfunktionen vorgesehen Leuchtmittel 02, 03, 04, 05, 06 jeweils Gutzustand aufweisen. Entsprechend zeigt der Empfang eines als Diagnosesignal Idiag dienenden Summendiagnosestroms am Ende der Diagnoseleitung 07 mit einer Stromstärke in einer Höhe, die sich nur in einer Kombination eines oder mehrerer Einzeldiagnoseströme unter Beitrag des der Diagnoseleitung 07 zugeordneten Einzeldiagnosestroms ergibt, an, dass die Diagnoseleitung 07 intakt ist und welches eine oder welche mehrere zur Erfüllung einer oder mehrerer momentan benötigten Lichtfunktionen vorgesehen Leuchtmittel 02, 03, 04, 05, 06 Schlechtzustand aufweisen.

Eine zuvor beschriebene und beispielsweise in Fig. 1 oder in Fig. 2 dargestellte Kraftfahrzeugleuchte 01 erlaubt die Durchführung eines Verfahrens zur Erzeugung eines Diagnosesignals Idiag einer Kraftfahrzeugleuchte 01, welche über mehrere zur Erfüllung mindestens einer Lichtfunktion der Kraftfahrzeugleuchte 01 vorgesehene, jeweils wenigstens eine Lichtquelle 10 umfassende Leuchtmittel 02, 03, 04, 05, 06 verfügt, von denen wenigstens zwei Leuchtmittel 02, 03, 04, 05, 06 mit jeweils einer Ausfallerkennung 11 für eine oder mehrere ihrer Lichtquellen 10 ausgestattet sind. Das Diagnosesignal Idiag ist zur Übertragung an ein Steuergerät eines Kraftfahrzeugs via einer einzigen Diagnoseleitung 07 vorgesehen. Das Diagnosesignal Idiag zeigt die einem Gutzustand entsprechende ordnungsgemäße Funktion und/oder die einem Schlechtzustand entsprechende, nicht ordnungsgemäße Funktion eines oder mehrerer zur Erfüllung mindestens einer momentan benötigten Lichtfunktion vorgesehener und mit einer Ausfallerkennung 11 ausgestatteter Leuchtmittel 02, 03, 04, 05, 06 der Kraftfahrzeugleuchte 01 an und ordnet Gut- und Schlechtzustände diesen Leuchtmitteln 02, 03, 04, 05, 06 eindeutig zu.

Das Verfahren sieht hierzu ein Diagnosesignal Idiag in Form eines Diagnosestroms vor, welches einem Summendiagnosestrom aus einem oder mehreren Einzeldiagnoseströmen entspricht. Dabei sieht das Verfahren vor, jeder Ausfallerkennung 11 eines mit einer Ausfallerkennung 11 ausgestatteten Leuchtmittels 02, 03, 04, 05, 06 ein Einzeldiagnosestrom vorgegebener Stromstärke zuzuordnen. Ferner sieht das Verfahren vor, dass jede Summe jeder beliebigen Kombination von den Ausfallerkennungen 11 zugeordneten Einzeldiagnoseströmen eine Stromstärke des das Diagnosesignal Idiag bildenden Summendiagnosestroms in einer solchen Höhe zur Folge hat, welche einen eindeutigen Rückschluss auf diejenigen zur Erfüllung einer oder mehrerer momentan benötigter Lichtfunktionen der Kraftfahrzeugleuchte 01 vorgesehenen Leuchtmittel 02, 03, 04, 05, 06 zulässt, welche sich im Gutzustand befinden, sowie auf diejenigen zur Erfüllung einer oder mehrerer momentan benötigter Lichtfunktionen der Kraftfahrzeugleuchte 01 vorgesehenen Leuchtmittel 02, 03, 04, 05, 06, die sich im Schlechtzustand befinden.

Das Verfahren kann demnach vorsehen, in einem ersten Verfahrensschritt festzustellen, welche Leuchtmittel 02, 03, 04, 05, 06 zur Erfüllung einer oder mehrerer momentan benötigter Lichtfunktionen zu betreiben sind. Diese Feststellung kann beispielsweise anhand der beispielsweise seitens des Kraftfahrzeugs geschalteten Stromversorgungen für die einzelnen Leuchtmittel 02, 03, 04, 05, 06 erfolgen.

Anschließend wird in einem zweiten Verfahrensschritt anhand der Ausfallerkennungen 11 der zur Erfüllung einer oder mehrerer momentan benötigter Lichtfunktionen betriebenen Leuchtmittel 02, 03, 04, 05, 06 deren jeweiliger Zustand ermittelt. Dabei kann jedes Leuchtmittel 02, 03, 04, 05, 06 einen Gutzustand aufweisen, der die ordnungsgemäße Funktion des jeweiligen Leuchtmittels 02, 03, 04, 05, 06 widerspiegelt, sowie einen Schlechtzustand, bei dem die Funktion des jeweiligen Leuchtmittels 02, 03, 04, 05, 06 durch Ausfall einer oder mehrerer Lichtquellen 10 des Leuchtmittels 02, 03, 04, 05, 06 eingeschränkt ist oder das Leuchtmittel 02, 03, 04, 05, 06 ganz ausgefallen ist.

In einem dritten Verfahrensschritt sieht das Verfahren vor, vorzugsweise jedem Gutzustand, alternativ jedoch auch denkbar jedem Schlechtzustand einen Einzeldiagnosestrom zuzuordnen, dessen Stromstärke vorzugsweise ausgehend von einem voreingestellten Grundstromstärkeniveau IG einer für jedes Leuchtmittel 02, 03, 04, 05, 06 individuellen Potenz PI einer Potenzreihe proportional ist. Die individuellen Potenzen PI der Potenzreihe sind dabei für verschiedene, jeweils einem Leuchtmittel 02, 03, 04, 05, 06 zugeordnete Ausfallerkennungen 11 unterschiedlich.

Dabei wird nur denjenigen Leuchtmitteln 02, 03, 04, 05, 06 ein Einzeldiagnosestrom zugeordnet, die zur Erfüllung einer oder mehrerer momentan benötigten Lichtfunktionen der Kraftfahrzeugleuchte 01 momentan benötigt werden.

Die Zuordnung ist dabei bevorzugt fix, wobei jedem Leuchtmittel 02, 03, 04, 05, 06 ein Einzeldiagnosestrom entsprechender Stromstärke zugeordnet bleibt, auch wenn ein Leuchtmittel 02, 03, 04, 05, 06 momentan nicht betrieben wird und dessen Zustand damit momentan keiner Erfassung unterliegt.

Leuchtmittel 02, 03, 04, 05, 06, die zur Erfüllung der momentan benötigten Lichtfunktionen nicht betrieben werden, können demnach Einzeldiagnoseströme bestimmter Höhe zugeordnet bleiben, jedoch leisten diese weder in deren Gutzustand, noch in deren Schlechtzustand einen Beitrag zum als Diagnosesignal Idiag dienenden Summendiagnosestrom, wenn die durch sie zu verwirklichenden Lichtfunktionen momentan nicht benötigt werden und momentan ausgeschaltet sind.

In einem vierten Verfahrensschritt sieht das Verfahren vor, einen ein Diagnosesignal Idiag bildenden Summendiagnosestrom zu erzeugen und via einer Diagnoseleitung 07 auszugeben, dessen Stromstärke der Summe der Stromstärken aller den erfassten Zuständen der zur Erfüllung der momentan benötigten Lichtfunktionen der Kraftfahrzeugleuchte 01 vorgesehenen Leuchtmitteln 02, 03, 04, 05, 06 zugeordneten Einzeldiagnoseströmen entspricht.

In einem fünften Verfahrensschritt kann eine mit der Diagnoseleitung 07 verbundene Auswerteeinrichtung, beispielsweise ein mit der Diagnoseleitung 07 verbundenes Steuergerät eines Kraftfahrzeugs, anhand der Höhe der Stromstärke des durch den Summendiagnosestrom gebildeten Diagnosesignals Idiag die Zustände aller zur Erfüllung der momentan benötigten Lichtfunktionen der Kraftfahrzeugleuchte 01 vorgesehenen Leuchtmittel 02, 03, 04, 05, 06 exakt bestimmen und zuordnen.

Ein optionaler Verfahrensschritt kann vorsehen, der Diagnoseleitung 07 ebenfalls einen Einzeldiagnosestrom zuzuordnen, der ebenfalls ausgehend vom voreingestellten Grundstromstärkeniveau IG einer individuellen Potenz PL einer Potenzreihe proportional ist. Vorzugsweise handelt es sich hierbei um die nullte Potenz und damit um eine direkte Proportionalität zum Grundstromstärkeniveau IG, bei dem die Stromstärke IL des der Diagnoseleitung zugeordneten Einzeldiagnosestromn dem Grundstromstärkeniveau IG entspricht.

Um den ordnungsgemäßen Zustand der Diagnoseleitung 07 anzuzeigen, kann dieser der Diagnoseleitung 07 zugeordnete Einzeldiagnosestrom beispielsweise fließen, wenn keine Lichtfunktion momentan benötigt wird.

Wichtig ist hervorzuheben, dass das Verfahren vorsehen kann, dass:
- jeder Ausfallerkennung 11 ein Einzeldiagnosestrom zugeordnet ist, dessen Stromstärke jeweils individuell proportional einem vorgegebenen Grundstromstärkeniveau IG ist, und/oder
- das Grundstromstärkeniveau IG eine Höhe von 1 µA bis 1 A aufweist, und/oder
- jeder Ausfallerkennung 11 ein Einzeldiagnosestrom zugeordnet ist, dessen Stromstärke jeweils proportional einer individuellen Potenz und damit einem individuellen Wert einer Potenzreihe ist. Die individuellen Werte der Potenzreihe sind dabei für verschiedene, jeweils einem Leuchtmittel 02, 03, 04, 05, 06 zugeordnete Ausfallerkennungen 11 unterschiedlich.
- eine Zweierpotenzreihe als Potenzreihe dient, wie sie aus der Erzeugung von Zahlen des Dezimalsystems anhand von Binärzahlen bekannt ist, und/oder
- jeder Ausfallerkennung 11 eines zur Erfüllung einer oder mehrerer momentan benötigten Lichtfunktionen der Kraftfahrzeugleuchte 01 vorgesehenen Leuchtmittels 02, 03, 04, 05, 06 ihr jeweiliger Einzeldiagnosestrom derart zugeordnet ist, dass dieser im Gutzustand bei ordnungsgemäßer Funktion des jeweiligen Leuchtmittels 02, 03, 04, 05, 06 fließt, wenn dieses zur Erfüllung einer oder mehrerer momentan benötigten Lichtfunktionen der Kraftfahrzeugleuchte 01 betrieben wird bzw. betrieben werden soll, und/oder
- der Diagnoseleitung 07 selbst eine Ausfallerkennung in Form eines eigenen Einzeldiagnosestroms beispielsweise mit einer in ihrer Höhe einer eigenen Potenz PL eines Grundstromstärkeniveaus IG proportionalen Stromstärke in Höhe von PL*I Ampere zugeordnet ist, der wiederum einen Teil des das Diagnosesignal Idiag bildenden Summendiagnosestroms bilden kann, und/oder
- entsprechend dem Ausführungsbeispiel einer in Fig. 2 dargestellten Kraftfahrzeugleuchte 01 die Ausfallerkennungen 11 innerhalb der Kraftfahrzeugleuchte 01 jeweils eigene Ausfallerkennungssignale an eine beispielsweise durch eine Schaltungsanodnung 16 gebildete Sammelstelle innerhalb der Kraftfahrzeugleuchte 01 senden, wobei an der Sammelstelle entsprechend der vorhandenen oder nicht vorhandenen Ausfallerkennungssignale der als Diagnosesignal Idiag dienende Summendiagnosestrom erzeugt wird, das beispielsweise via eines Anschlusses 12 an eine Verlängerung der Diagnoseleitung 07 ausgegeben wird, die mit einem Steuergerät eines Kraftfahrzeugs verbunden sein kann, und/oder
- entsprechend dem Ausführungsbeispiel einer in Fig. 1 dargestellten Kraftfahrzeugleuchte 01 jede Ausfallerkennung 11 innerhalb der Kraftfahrzeugleuchte 01 einen Einzeldiagnosestrom an eine durch eine mit den Ausgängen 14 verbundene Diagnoseleitung 07 gebildete Sammelstelle übermittelt, welche an der Sammelstelle zum als Diagnosesignal Idiag dienenden Summendiagnosestrom zusammengeführt werden und der Summendiagnosestrom beispielsweise via via eines Anschlusses 12 an eine Verlängerung der Diagnoseleitung 07 ausgegeben wird, die mit einem Steuergerät eines Kraftfahrzeugs verbunden sein kann.

Die Erfindung ist insbesondere im Bereich der Herstellung und des Betriebs von Kraftfahrzeugleuchten 01 gewerblich anwendbar.

### Bezugszeichenliste

- 01: Kraftfahrzeugleuchte
- 02: Leuchtmittel
- 03: Leuchtmittel
- 04: Leuchtmittel
- 05: Leuchtmittel
- 06: Leuchtmittel
- 07: Diagnoseleitung
- 08: Schaltkreis
- 09: Schaltkreis
- 10: Lichtquelle
- 11: Ausfallerkennung
- 12: Anschluss
- 13: Zuordnungsmittel
- 14: Ausgang
- 15: Eingang
- 16: Schaltungsanordnung
- 17: Mittel
- Idiag: Diagnosesignal

## Patentansprüche

1. Verfahren zur Erzeugung eines Diagnosesignals (Idiag) einer Kraftfahrzeugleuchte (01), welche über mehrere zur Erfüllung mindestens einer Lichtfunktion der Kraftfahrzeugleuchte (01) vorgesehene, jeweils wenigstens eine Lichtquelle (10) umfassende Leuchtmittel (02, 03, 04, 05, 06) verfügt, von denen wenigstens zwei mit jeweils einer Ausfallerkennung (11) für eine oder mehrere ihrer Lichtquellen (10) ausgestattet sind, welches Diagnosesignal (Idiag) via einer einzigen Diagnoseleitung (07) übertragen die einem Gutzustand entsprechende ordnungsgemäße Funktion und/oder die einem Schlechtzustand entsprechende, nicht ordnungsgemäße Funktion eines oder mehrerer zur Erfüllung mindestens einer momentan benötigten Lichtfunktion vorgesehener Leuchtmittel (02, 03, 04, 05, 06) der Kraftfahrzeugleuchte (01) anzeigt und Gut- und Schlechtzustände diesen Leuchtmitteln (02, 03, 04, 05, 06) eindeutig zuordnet, **gekennzeichnet durch**
ein Diagnosesignal (Idiag) in Form eines Diagnosestroms, welches einem Summendiagnosestrom (Idiag) aus einem oder mehreren Einzeldiagnoseströmen entspricht, wobei:
- jeder Ausfallerkennung (11) eines mit einer Ausfallerkennung (11) ausgestatteten Leuchtmittels (02, 03, 04, 05, 06) ein Einzeldiagnosestrom vorgegebener Stromstärke zugeordnet ist, und
- jede Summe jeder beliebigen Kombination von den Ausfallerkennungen (11) zugeordneten Einzeldiagnoseströmen eine Stromstärke des Summendiagnosestroms (Idiag) in einer solchen Höhe zur Folge hat, welche einen eindeutigen Rückschluss auf diejenigen zur Erfüllung einer oder mehrerer momentan benötigter Lichtfunktionen der Kraftfahrzeugleuchte (01) vorgesehenen Leuchtmittel (02, 03, 04, 05, 06) zulässt, welche sich im Gutzustand befinden, sowie auf diejenigen zur Erfüllung einer oder mehrerer momentan benötigter Lichtfunktionen der Kraftfahrzeugleuchte (01) vorgesehenen Leuchtmittel (02, 03, 04, 05, 06), die sich im Schlechtzustand befinden.

2. Verfahren nach Anspruch 1,
**dadurch gekennzeichnet,**
**dass** jeder Ausfallerkennung (11) ein Einzeldiagnosestrom zugeordnet ist, dessen Stromstärke jeweils individuell proportional einem vorgegebenen Grundstromstärkeniveau (IG) ist.

3. Verfahren nach Anspruch 2,
**gekennzeichnet durch**
ein Grundstromstärkeniveau (IG) in Höhe von 1 µA bis 1A.

4. Verfahren nach Anspruch 1, 2 oder 3,
**dadurch gekennzeichnet,**
**dass** jeder Ausfallerkennung (11) ein Einzeldiagnosestrom zugeordnet ist, dessen Stromstärke jeweils proportional einer individuellen Potenz (PI) einer Potenzreihe ist.

5. Verfahren nach Anspruch 4,
**gekennzeichnet durch**,
eine Zweierpotenzreihe als Potenzreihe.

6. Verfahren nach einem der voranstehenden Ansprüche,
**dadurch gekennzeichnet,**
**dass** jeder Ausfallerkennung (11) ihr jeweiliger Einzeldiagnosestrom derart zugeordnet ist, dass dieser im Gutzustand des jeweiligen Leuchtmittels (02, 03, 04, 05, 06) fließt, wenn dieses zur Erfüllung einer oder mehrerer momentan benötigten Lichtfunktionen der Kraftfahrzeugleuchte (01) betrieben wird.

7. Verfahren nach einem der voranstehenden Ansprüche,
**dadurch gekennzeichnet,**
**dass** der Diagnoseleitung (07) selbst eine Ausfallerkennung in Form eines eigenen Einzeldiagnosestroms zugeordnet ist.

8. Verfahren nach einem der voranstehenden Ansprüche,
**dadurch gekennzeichnet,**
**dass** die Ausfallerkennungen (11) innerhalb der Kraftfahrzeugleuchte (01) jeweils eigene Ausfallerkennungssignale an eine Sammelstelle (16) innerhalb der Kraftfahrzeugleuchte (01) senden, wobei an der Sammelstelle (16) entsprechend der vorhandenen oder nicht vorhandenen Ausfallerkennungssignale der Summendiagnosestrom (Idiag) erzeugt wird.

9. Verfahren nach einem der Ansprüche 1 bis 7,
**dadurch gekennzeichnet,**
**dass** jede Ausfallerkennung (11) innerhalb der Kraftfahrzeugleuchte (01) einen Einzeldiagnosestrom an eine Sammelstelle (07) übermittelt, welche an der Sammelstelle (07) zum Summendiagnosestrom (Idiag) zusammengeführt werden.

10. Kraftfahrzeugleuchte (01) zur Durchführung eines Verfahrens nach einem der voranstehenden Ansprüche, welche mehrere zur Erfüllung einer oder mehrerer Lichtfunktionen der Kraftfahrzeugleuchte (01) vorgesehene Leuchtmittel (02, 03, 04, 05, 06) mit jeweils einer oder mehreren Lichtquellen (10) umfasst, von denen mindestens zwei mit einer Ausfallerkennung (11) für eine oder mehrere Lichtquellen (10) des jeweiligen Leuchtmittels (02, 03, 04, 05, 06) ausgestattet sind, sowie über einen Anschluss (12) für eine Diagnoseleitung (07) verfügt, via welcher ein Diagnosesignal (Idiag) ausgegeben wird, welchem eindeutig einer ordnungsgemäßen Funktion entsprechende Gutzustände und/oder einer nicht ordnungsgemäßen Funktion entsprechende Schlechtzustände zumindest desjenigen oder derjenigen mit einer Ausfallerkennung (11) ausgestatteter Leuchtmittel (02, 03, 04, 05, 06) der Kraftfahrzeugleuchte (01) entnehmbar sind, welche zur Erfüllung der einen oder mehreren momentan benötigten Lichtfunktionen der Kraftfahrzeugleuchte (01) zu betreiben sind, **gekennzeichnet durch**
Zuordnungsmittel (13), die jeder Ausfallerkennung (11) einen eindeutige Einzeldiagnosestrom in Höhe einer solchen Stromstärke zuordnen, dass die Summe beliebiger unterschiedlicher Kombinationen von Einzeldiagnoseströmen Summendiagnoseströme verschiedener Stromstärke zur Folge haben, die als Diagnosesignal (Idiag) via des Anschlusses (12) für die Diagnoseleitung (07) ausgegeben wiederum eine eindeutige Identifikation von anhand der Ausfallerkennungen (11) ermittelter Leuchtmittel (02, 03, 04, 05, 06) im Gutzustand und Leuchtmittel (02, 03, 04, 05, 06) im Schlechtzustand zulassen, wobei:
- die Zuordnungsmittel (13) über einen Ausgang (14) verfügen, der mit dem Anschluss (12) für die Diagnoseleitung (07) verbunden ist, und
- die Zuordnungsmittel (13) über mehrere mit den Ausfallerkennungen (11) der entsprechend ausgestatteten Leuchtmittel (02, 03, 04, 05, 06) verbundene Eingänge (15) verfügen, von denen je ein Eingang (15) mit einer Ausfallerkennung (11) eines Leuchtmittels (02, 03, 04, 05, 06) verbunden ist.

11. Kraftfahrzeugleuchte nach Anspruch 10,
**dadurch gekennzeichnet,**
**dass** die Zuordnungsmittel (13) durch eine Stromsummierungsschaltung verwirklicht sind, wobei jede Ausfallerkennung (11) ihren eigenen Einzeldiagnosestrom erzeugt, und von der Stromsummierungsschaltung die Einzeldiagnoseströme der einzelnen Ausfallerkennungen (11) zum Summendiagnosestrom (Idiag) addiert werden.

12. Kraftfahrzeugleuchte nach Anspruch 10,
**dadurch gekennzeichnet,**
**dass** die Zuordnungsmittel (13) durch eine Schaltungsanordnung (16) verwirklicht sind, welche jedem an einem Eingang (15) eintreffenden Signal einer Ausfallerkennung (11) einen bestimmten Einzeldiagnosestrom zuordnet und anschließend die Einzeldiagnoseströme zum Summendiagnosestrom (Idiag) addiert.

13. Kraftfahrzeugleuchte nach einem der Ansprüche 10, 11 oder 12,
**dadurch gekennzeichnet,**
**dass** die Kraftfahrzeugleuchte (01) Mittel (17) zur Ausfallerkennung der Diagnoseleitung (07) umfasst, welche Mittel (17) zur Ausfallerkennung einen oder mehrere Schaltkreise (08, 09) umfassen, die einen der Diagnoseleitung (07) zugeordneten Einzeldiagnosestrom mit einer Stromstärke in solcher Höhe erzeugen, welche in beliebiger unterschiedlicher Kombinationen mit keinem oder einem oder mehreren den Ausfallerkennungen (11) der Leuchtmittel (02, 03, 04, 05, 06) zugeordneten Einzeldiagnoseströmen Summendiagnoseströme verschiedener Stromstärke zur Folge hat, die wiederum eine eindeutige Identifikation von anhand der Ausfallerkennungen (11) ermittelter Leuchtmittel (02, 03, 04, 05, 06) im Gutzustand und Leuchtmittel (02, 03, 04, 05, 06) im Schlechtzustand und/oder einer ordnungsgemäß verbundenen Diagnoseleitung (07) zulässt.

14. Kraftfahrzeugleuchte nach einem der Ansprüche 10 bis 13,
**dadurch gekennzeichnet,**
**dass** wenigstens ein mit einer Ausfallerkennung (11) ausgestattetes Leuchtmittel (02, 03, 04, 05, 06) zumindest eine LED als Lichtquelle (10) umfasst.

15. Kraftfahrzeugleuchte nach einem der Ansprüche 10 bis 14,
**dadurch gekennzeichnet,**
**dass** die Kraftfahrzeugleuchte (01):
- als eine Heckleuchte, oder
- als ein Scheinwerfer, oder
- als eine Tagfahrleuchte, oder
- als ein Nebelscheinwerfer und/oder eine Abbiegeleuchte, oder
- als eine hoch gesetzte dritte Bremsleuchte, oder
- als eine Nebelschlussleuchte
für ein Kraftfahrzeug ausgebildet ist,
und/oder
**dass** die Kraftfahrzeugleuchte (01) zur Erfüllung zumindest:
- einer Abblendlichtfunktion, und/oder
- einer Tagfahrlichtfunktion, und/oder
- einer Abbiegelichtfunktion, und/oder
- einer Nebelscheinwerferlichtfunktion, und/oder
- einer Nebelschlusslichtfunktion, und/oder
- einer Bremslichtfunktion, und/oder
- einer Schlusslichtfunktion, und/oder
- einer Begrenzungslichtfunktion, und/oder
- einer Widerholblinklichtfunktion, und/oder
- einer Rückfahrlichtfunktion
eines Kraftfahrzeugs ausgeführt ist.

## Claims

1. A method for generating a diagnostic signal (Idiag) of a motor vehicle lamp (01) having a plurality of lighting means (02, 03, 04, 05, 06), each comprising at least one light source (10) and being provided for fulfilling at least one light function of the motor vehicle lamp (01), at least two of which lighting means (02, 03, 04, 05, 06) are each equipped with a failure detector (11) for one or more of their light sources (10), which diagnostic signal (Idiag) transmitted via one single diagnostic line (07) indicates the proper function corresponding to a GOOD status and/or the improper function corresponding to a BAD status of one or more of the motor vehicle lamp's (01) lighting means (02, 03, 04, 05, 06) provided for fulfilling at least one presently required light function, and uniquely assigns GOOD and BAD statuses to these lighting means (02, 03, 04, 05, 06),
**characterised by**
a diagnostic signal (Idiag) in the form of a diagnostic current, which corresponds to a sum diagnostic current (Idiag) of one or more individual diagnostic currents, wherein:
- each failure detector (11) of a lighting means (02, 03, 04, 05, 06) that is equipped with a failure detector (11) is assigned an individual diagnostic current of a predetermined amperage, and
- each sum of any optional combination of the individual diagnostic currents assigned to the failure detectors (11) results in a sum diagnostic current (Idiag) of such an amperage level that allows a unique inference on those one or more of the motor vehicle lamp's (01) lighting means (02, 03, 04, 05, 06) that are provided for fulfilling one or more of the presently required light functions and that have a GOOD status, and on those one or more of the motor vehicle lamp's (01) lighting means (02, 03, 04, 05, 06) that are provided for fulfilling one or more of the presently required light functions and that have a BAD status.

2. The method as recited in claim 1,
**characterised in that**
each failure detector (11) is assigned an individual diagnostic current of an amperage that is individually proportional, respectively, to a predetermined basic amperage level (IG).

3. The method as recited in claim 2,
**characterised by**
a basic amperage level (IG) of 1 µA to 1 A.

4. The method as recited in claim 1, 2 or 3,
**characterised in that**
each failure detector (11) is assigned an individual diagnostic current of an amperage that is respectively proportional to an individual power (PI) of a power series.

5. The method as recited in claim 4,
**characterised by**
a power of two series as power series.

6. The method as recited in one of the preceding claims,
**characterised in that**
each failure detector (11) is assigned its respective individual diagnostic current in such a manner that, in the GOOD state of the respective lighting means (02, 03, 04, 05, 06), this individual diagnostic current flows, when said lighting means (02, 03, 04, 05, 06) is operated for fulfilling one or more of the motor vehicle lamp's (01) presently required light functions.

7. The method as recited in one of the preceding claims,
**characterised in that**
the diagnostic line (07) itself is assigned a failure detector in the form of an individual diagnostic current of its own.

8. The method as recited in one of the preceding claims,
**characterised in that**
the failure detectors (11) within the motor vehicle lamp (01) send their own respective failure detection signals to a collection point (16) within the motor vehicle lamp (01) wherein the sum diagnostic current (Idiag) is generated at the collection point (16) according to the present or absent failure detection signals.

9. The method as recited in one of the claims 1 to 7,
**characterised in that**
each failure detector (11) within the motor vehicle lamp (01) transmits an individual diagnostic current to a collection point, which individual diagnostic currents are collected at the collection point in the sum diagnostic current (Idiag).

10. A motor vehicle lamp (01) for carrying out a method as recited in one of the preceding claims, which motor vehicle lamp (01) comprises a plurality of lighting means (02, 03, 04, 05, 06), each having one or more light sources (10) and being provided for fulfilling one or more light functions of the motor vehicle lamp (01), at least two of which lighting means (02, 03, 04, 05, 06) are equipped with a failure detector (11) for one or more light sources (10) of the respective lighting means (02, 03, 04, 05, 06), as well as having a connection (12) for a diagnostic line (07), via which a diagnostic signal (Idiag) is output, which enables uniquely inferring the GOOD statuses corresponding to a proper function and/or the BAD statuses corresponding to an improper function of at least that or those of the motor vehicle lamp's (01) lighting means (02, 03, 04, 05, 06) that is or are equipped with a failure detector (11) and that has or have to be operated for fulfilling one or more of the presently required light functions of the motor vehicle lamp (01), **characterised by**
assignment means (13), which assign to each failure detector (11) a unique individual diagnostic current of such an amperage that the sum of optional different combinations of individual diagnostic currents result in sum diagnostic currents of different amperages, which, output as a diagnostic signal (Idiag) via the connection (12) for the diagnostic line (07), in turn allow a unique identification of lighting means (02, 03, 04, 05, 06) with GOOD status and lighting means (02, 03, 04, 05, 06) with BAD status determined by means of the failure detectors (11), wherein:
- the assignment means (13) have an output (14), which is connected with the connection (12) for the diagnostic line (07), and
- the assignment means (13) have a plurality of inputs (15) connected with the failure detectors (11) of the correspondingly equipped lighting means (02, 03, 04, 05, 06), respectively one input (15) of which is connected with one failure detector (11) of a lighting means (02, 03, 04, 05, 06).

11. The motor vehicle lamp as recited in claim 10,
**characterised in that**
the assignment means (13) are realised by means of a current summation circuit, wherein each failure detector (11) generates its own individual diagnostic current, and the individual diagnostic currents of the individual failure detectors (11) are summed up to the sum diagnostic current (Idiag) by the current summation circuit.

12. The motor vehicle lamp as recited in claim 10,
**characterised in that**
the assignment means (13) are realised by means of a circuit configuration (16), which assigns a specific individual diagnostic current to each signal of a failure detector (11) arriving at an input (15) and subsequently sums up the individual diagnostic currents to the sum diagnostic current (Idiag).

13. The motor vehicle lamp as recited in one of the claims 10, 11 or 12, **characterised in that**
the motor vehicle lamp (01) comprises means (17) for failure detection of the diagnostic line (07), which means (17) for failure detection comprises one or more circuits (08, 09) generating an individual diagnostic current assigned to the diagnostic line (07) and of such an amperage level that results in sum diagnostic currents of different amperages in optional different combinations with none or with one or more of the individual diagnostic currents assigned to the failure detectors (11) of the lighting means (02, 03, 04, 05, 06), which amperage in turn allows a unique identification of lighting means (02, 03, 04, 05, 06) with GOOD status and lighting means (02, 03, 04, 05, 06) with BAD status that were determined by means of the failure detectors (11) and/or a unique identification of a properly connected diagnostic line (07).

14. The motor vehicle lamp as recited in one of the claims 10 to 13,
**characterised in that**
at least one of the lighting means (02, 03, 04, 05, 06) equipped with a failure detection (11) comprises at least one LED as a light source (10).

15. The motor vehicle lamp as recited in one of the claims 10 to 14,
**characterised in that**
the motor vehicle lamp (01) is constructed:
- as a tail lamp, or
- as a headlamp, or
- as a daytime running lamp, or
- as a fog lamp and/or a direction indicator lamp, or
- as a high-mounted, third brake lamp, or
- as a fog rear lamp
for a motor vehicle,
and/or
**in that** the motor vehicle lamp (01) is designed for fulfilling at least:
- a low-beam lamp function, and/or
- a daytime running lamp function, and/or
- a direction indicator lamp function, and/or
- a fog lamp function, and/or
- a fog rear lamp function, and/or
- a brake lamp function, and/or
- a tail lamp function, and/or
- a side lamp function, and/or
- a repeat indicator lamp function, and/or
- a reverse lamp function
of a motor vehicle.

## Revendications

1. Procédé de génération d'un signal de diagnostic (Idiag) d'une lampe de véhicule automobile (01) qui dispose d'une pluralité de moyens lumineux (02, 03, 04, 05, 06) qui sont prévus pour remplir au moins une fonction de lumière de ladite lampe de véhicule automobile (01) et comprennent chacun au moins une source de lumière (10) et dont au moins deux sont munis de respectivement une détection de défaillance (11) pour une ou plusieurs de leurs sources de lumière (10), lequel signal de diagnostic (Idiag), transmis via une seule ligne de diagnostic (07), indique la fonction régulière correspondant à un bon état et/ou la fonction irrégulière correspondant à un mauvais état, d'un ou de plusieurs moyens lumineux (02, 03, 04, 05, 06) de la lampe de véhicule automobile (01) prévus pour remplir au moins une fonction de lumière dont on a actuellement besoin, et associe de manière univoque de bons et de mauvais états à ces moyens lumineux (02, 03, 04, 05, 06),
**caractérisé par**
un signal de diagnostic (Idiag) sous forme d'un courant de diagnostic, qui correspond à un courant de diagnostic cumulé (Idiag) d'un ou de plusieurs courants de diagnostic individuels, dans lequel:
- à chaque détection de défaillance (11) d'un moyen lumineux (02, 03, 04, 05, 06) muni d'une détection de défaillance (11) est associé un courant de diagnostic individuel d'une intensité de courant donnée, et
- chaque somme de n'importe quelle combinaison de courants de diagnostic individuels associés aux détections de défaillance (11) a pour conséquence une intensité de courant du courant de diagnostic cumulé (Idiag) d'une telle importance qui permet de conclure de manière univoque à ceux des moyens lumineux (02, 03, 04, 05, 06) prévus pour remplir une ou plusieurs fonctions de lumière de la lampe de véhicule automobile (01) dont on a actuellement besoin, qui se trouvent en bon état ainsi qu'à ceux des moyens lumineux (02, 03, 04, 05, 06) prévus pour remplir une ou plusieurs fonctions de lumière de la lampe de véhicule automobile (01) dont on a actuellement besoin, qui se trouvent en mauvais état.

2. Procédé selon la revendication 1, **caractérisé par le fait qu'**à chaque détection de défaillance (11) est associé un courant de diagnostic individuel dont l'intensité de courant est respectivement individuellement proportionnelle à un niveau d'intensité de courant de base (IG) donné.

3. Procédé selon la revendication 2, **caractérisé par** un niveau d'intensité de courant de base (IG) compris entre 1 µA et 1 A.

4. Procédé selon la revendication 1, 2 ou 3, **caractérisé par le fait qu'**à chaque détection de défaillance (11) est associé un courant de diagnostic individuel dont l'intensité de courant est respectivement proportionnelle à une puissance individuelle (PI) d'une série de puissances.

5. Procédé selon la revendication 4, **caractérisé par** une série de puissances de deux en tant que série de puissances.

6. Procédé selon l'une quelconque des revendications précédentes, **caractérisé par le fait qu'**à chaque détection de défaillance (11) est associé son courant de diagnostic individuel respectif de telle sorte que celui-ci circule en bon état du moyen lumineux (02, 03, 04, 05, 06) respectif lorsque celui-ci est opéré pour remplir une ou plusieurs fonctions de lumière de la lampe de véhicule automobile (01) dont on a actuellement besoin.

7. Procédé selon l'une quelconque des revendications précédentes, **caractérisé par le fait qu'**à la ligne de diagnostic (07) même est associée une détection de défaillance sous forme d'un propre courant de diagnostic individuel.

8. Procédé selon l'une quelconque des revendications précédentes, **caractérisé par le fait que** les détections de défaillance (11) à l'intérieur de la lampe de véhicule automobile (01) émettent chacune de propres signaux de détection de défaillance à un point collecteur (16) à l'intérieur de la lampe de véhicule automobile (01), le courant de diagnostic cumulé (Idiag) étant généré sur ledit point collecteur (16) en fonction des signaux de détection de défaillance présents ou absents.

9. Procédé selon l'une quelconque des revendications 1 à 7, **caractérisé par le fait que** chaque détection de défaillance (11) à l'intérieur de la lampe de véhicule automobile (01) transmet, à un point collecteur (16), un courant de diagnostic individuel qui sont réunis, sur ledit point collecteur (16), pour obtenir le courant de diagnostic cumulé (Idiag).

10. Lampe de véhicule automobile (01) pour la mise en oeuvre d'un procédé selon l'une quelconque des revendications précédentes, laquelle comprend une pluralité de moyens lumineux (02, 03, 04, 05, 06) qui sont prévus pour remplir une ou plusieurs fonctions de lumière de ladite lampe de véhicule automobile (01) et ont chacun une ou plusieurs sources de lumière (10) et dont au moins deux sont munis d'une détection de défaillance (11) pour une ou plusieurs sources de lumière (10) du moyen lumineux (02, 03, 04, 05, 06) respectif, et laquelle dispose d'une borne (12) pour une ligne de diagnostic (07) via laquelle est délivré un signal de diagnostic (Idiag) duquel on peut déduire de manière univoque de bons états correspondant à une fonction régulière et/ou de mauvais états correspondant à une fonction irrégulière, d'au moins du ou des moyens lumineux (02, 03, 04, 05, 06) de la lampe de véhicule automobile (01) munis d'une détection de défaillance (11), qui sont à opérer pour remplir ladite une ou lesdites plusieurs fonctions de lumière de la lampe de véhicule automobile (01) dont on a actuellement besoin,
**caractérisée par**
des moyens d'association (13) qui associent à chaque détection de défaillance (11) un courant de diagnostic individuel univoque d'une telle intensité de courant que la somme de combinaisons différentes quelconques de courants de diagnostic individuels a pour conséquence des courants de diagnostic cumulés d'intensité de courant différente qui, délivrés en tant que signal de diagnostic (Idiag) via ladite borne (12) pour la ligne de diagnostic (07), permettent à leur tour une identification univoque de moyens lumineux (02, 03, 04, 05, 06) en bon état et de moyens lumineux (02, 03, 04, 05, 06) en mauvais état qui sont détectés à l'aide des détections de défaillance (11),
dans laquelle:
- les moyens d'association (13) disposent d'une sortie (14) qui est reliée à ladite borne (12) pour la ligne de diagnostic (07), et
- les moyens d'association (13) disposent d'une pluralité d'entrées (15) qui sont reliées aux détections de défaillance (11) des moyens lumineux (02, 03, 04, 05, 06) équipés de manière correspondante et dont respectivement une entrée (15) est reliée à une détection de défaillance (11) d'un moyen lumineux (02, 03, 04, 05, 06).

11. Lampe de véhicule automobile selon la revendication 10, **caractérisée par le fait que** les moyens d'association (13) sont réalisés par un circuit de sommation de courants, chaque détection de défaillance (11) générant son propre courant de diagnostic individuel, et les courants de diagnostic individuels des détections de défaillance (11) individuelles sont additionnés par le circuit de sommation de courants pour obtenir le courant de diagnostic cumulé (Idiag).

12. Lampe de véhicule automobile selon la revendication 10, **caractérisée par le fait que** les moyens d'association (13) sont réalisés par un agencement de circuit (16) qui associe un courant de diagnostic individuel déterminé à chaque signal d'une détection de défaillance (11) qui arrive à une entrée (15), et qui additionne ensuite les courants de diagnostic individuels pour obtenir le courant de diagnostic cumulé (Idiag).

13. Lampe de véhicule automobile selon l'une quelconque des revendications 10, 11 ou 12, **caractérisée par le fait que** la lampe de véhicule automobile (01) comprend des moyens (17) de détection de défaillance de la ligne de diagnostic (07), lesquels moyens (17) de détection de défaillance comprennent un ou plusieurs circuits (08, 09) qui génèrent un courant de diagnostic individuel associé à la ligne de diagnostic (07) et ayant une intensité de courant d'une telle importance qui a pour conséquence, dans des combinaisons différentes quelconques avec aucun ou un ou plusieurs courants de diagnostic individuels associés aux détections de défaillance (11) des moyens lumineux (02, 03, 04, 05, 06), des courants de diagnostic cumulés d'intensité de courant différente qui permet à son tour une identification univoque de moyens lumineux (02, 03, 04, 05, 06) en bon état et de moyens lumineux (02, 03, 04, 05, 06) en mauvais état qui sont détectés à l'aide des détections de défaillance (11), et/ou d'une ligne de diagnostic (07) connectée correctement.

14. Lampe de véhicule automobile selon l'une quelconque des revendications 10 à 13, **caractérisée par le fait qu'**au moins un moyen lumineux (02, 03, 04, 05, 06) muni d'une détection de défaillance (11) comprend au moins une DEL en tant que source de lumière (10).

15. Lampe de véhicule automobile selon l'une quelconque des revendications 10 à 14, **caractérisée par le fait que** la lampe de véhicule automobile (01) est réalisée:
- comme un feu arrière ou
- comme un phare ou
- comme un feu de circulation diurne ou
- comme un phare antibrouillard et/ou un feu d'angle ou
- comme un troisième feu stop supplémentaire ou
- comme un feu-brouillard arrière
pour un véhicule automobile
et/ou
que la lampe de véhicule automobile (01) est conçue pour remplir au moins:
- une fonction de feu de croisement et/ou
- une fonction de feu de circulation diurne et/ou
- une fonction de feu d'angle et/ou
- une fonction de phare antibrouillard et/ou
- une fonction de feu-brouillard arrière et/ou
- une fonction de feu stop et/ou
- une fonction de feu arrière et/ou
- une fonction de feu de position et/ou
- une fonction de feu clignotant répété et/ou
- une fonction de feu de marche arrière
d'un véhicule automobile.
